# EUROPEAN PATENT APPLICATION

(11) **EP 4 793 993 A1**
(43) Date of publication of application: **19.08.2026**
(21) Application number: 25386010.0
(22) Date of filing: 14.02.2025
(51) Int. Cl.: H01L 23/367, H01L 23/473, H01L 21/48

(54) **COOLING ELEMENT AND STACK COMPRISING SUCH A COOLING ELEMENT**

(71) Applicant: Corintis SA, 1015 Lausanne (CH)
(72) Inventor: Francescon, Andrea, 1206 Genf (CH); Van Erp, Remco, 1004 Lausanne (CH); Salazar de Troya, Miguel Angel, 1007 Lausanne (CH); Boutsikakis, Athanasios, 1022 Chavannes-près-Renens (CH)
(74) Representative: Fuchs Patentanwälte Partnerschaft mbB

(57) **Abstract**

The present invention relates to a cooling element. The present invention also relates to a stack comprising such a cooling element.

## Description

The present invention relates to a cooling element. The present invention also relates to a stack comprising such a cooling element.

### Background of the invention

Cooling elements for cooling other elements such as semiconductor components, e.g. in form of and/or comprising computer chips, are well known in engineering. In addition to passive cooling elements with increased surface area acting as a heat sink, active cooling elements with additional forced cooling techniques are also widely used.

However, it is desirable to further improve the cooling efficiency of the cooling element when it is used to cool other elements from which heat is to be dissipated during use.

It is, thus, the object of the present invention to provide cooling elements with improved cooling efficiency when used to cool other elements from which heat is to be dissipated during use.

### Description of the invention

The problem is solved by the invention according to a first aspect in that a cooling element is proposed, the cooling element being configured for heat-transferring contact with another element from which heat is to be dissipated during use, the cooling element comprising
- one or more fins of at least one **first group of fins** arranged within at least one definable **first volume,** and
- one or more fins of at least one **second group of fins** arranged within at least one definable **second volume,**

wherein in a definable **superior volume** comprising the first volume and the second volume a **network of interconnected channels** for guiding a liquid cooling agent is provided,
wherein the fins of each of the first group of fins and the second group of fins contribute to the formation of boundaries of the channels of the network of interconnected channels at least in part,
wherein the fins of the first group of fins are arranged in a different pattern than the fins of the second group of fins.

The invention is based on the surprising finding that an improved cooling efficiency can be achieved when a local variation of the heat generation rate of the element from which heat will be dissipated is accounted for at least in part. By providing fins of respective first and second groups of fins, the flow of the liquid cooling agent can be adapted in light of the local variation of the heat generation. It turns out that by a respective adapted flow of the liquid cooling agent a highly flexible and fine-granular local variation of the cooling rate can be set up. Specifically, the arrangement of the fins of the first and second groups of fins such that they are arranged in different patterns surprisingly allows for a particular efficient cooling. It is further beneficial to adapt the flow in light of the local heat generation characteristic for the respective element to be cooled. This allows to realize a particular high overall cooling efficiency of the cooling element.

When designing the cooling element, the fins of the proposed groups of fins can be adapted in nearly any arbitrary way as required by the respective design of the element to be cooled. For example, the shape of the individual fins, the number of the fins and/or the distribution of the fins may be individually determined at least in regions, respectively, for the proposed groups of fins. In addition, this can be achieved in an easy and cost-efficient way. Hence, it is possible to improve the cooling efficiency of a cooling element for nearly every possible design of an element to be cooled, especially by adapting the fins of the different groups of fins in said manners.

Thus, it is preferred that the fins of the first and/or second groups of fins are provided at least implicitly based on a local variation of a heat generation rate of at least regions of the element from which heat is to be dissipated. For example, the local variation of the heat generation rate may be a local variation of the heat generation rate which particularly is or can be measured on at least one part of a surface of the element from which heat is to be dissipated during its use or within a simulation of a scenario comprising at least the element to be cooled.

The design of a preferred cooling element, hence, may incorporate a simulation of at least parts of the element to be cooled. For example, the simulation may alternatively or in addition comprise defining one or more constraints directed to the number of groups of fins, directed to the fact that the patterns according to which the fins of the respective groups of fins (especially the first and second groups of fins) are arranged are different and/or directed to properties of the patterns according to which the fins of the respective groups of fins are arranged. The design of a preferred cooling element may alternatively or in addition incorporate conducting an optimization algorithm. The optimization algorithm may be carried out on a computer based on one or more input data. The input data may comprise one or more design constraints. The one or more design constraints may be at least in part directed (i) to constraints with respect to geometric design aspects of the cooling element or parts thereof (e.g. one or more extensions of the cooling element and/or the superior volume and/or the first and/or second volume within which the respective fins are provided, respectively, along one or more directions and/or one or more statistical parameters concerning the design of the fins - as will be described in more detail below), (ii) to constraints with respect to physical properties of the cooling element or parts thereof (e.g. a required local variation of a cooling rate - for example as described above) and/or (iii) to constraints with respect to the element to be cooled (e.g. a local variation of a heat generation rate of the element to be cooled and/or one or more extensions of the element to be cooled along one or more directions) and/or (iv) to constraints with respect to the number of groups of fins, with respect to the fact that the patterns according to which the fins of the respective groups of fins (especially the first and second groups of fins) are arranged are different and/or with respect to properties of the patterns according to which the fins of the respective groups of fins are arranged. Further input data and/or design constraints may be provided, of course. As a result, the optimization algorithm may propose a design option for the cooling element or parts thereof, especially for the provision of the fins within the first volume and/or of the fins within the second volume, especially including aspects concerning their number, size, shape and/or distribution and/or aspects concerning the pattern according to which the fins of the first group of fins are arranged and/or the pattern according to which the fins of the second group of fins are arranged.

Therefore, and in general, when providing the fins in each case of the first group of fins and/or the fins of the second group of fins, aspects such as the number of fins, especially a minimum and/or maximum number of fins, general or individual aspects of the shapes (particularly viewed in a common cross-sectional plane of the cooling element) of the fins and/or a distribution of the fins within the respective first and/or second volume may be taken into account. In addition or alternatively, said aspects may be taken into account which apply to the fins across the first and second groups of fins. Hence the aspects may be taken into account for the fins of each group of fins (such as the first group of fins and the second group of fins) individually and/or for the fins across the groups of fins (such as the first group of fins and the second group of fins). In other words, provision of the fins may be based at least in part on aspects which are applied to the fins of each group of fins (such as the first group of fins and the second group of fins) individually and/or based at least in part on aspects which are applied to the fins across at least the first group of fins and the second group of fins.

The fins, thus, may determine at least in part the formation of the channels of the network of interconnected channels.

When the cooling element is in use, the local variation of the cooling rate is at least in part determined by the network of interconnected channels and/or the patterns according to which the fins of the respective groups of fins (such as the first group of fins and the second group of fins) are arranged. Therefore, in this application the network of interconnected channels is of particular relevance. Thus, it may not be required to identify a single individual channel among the channels of the network of interconnected channels in a unique manner. Actually, it may in addition even not be possible in many cases to identify a single individual channel among the channels of the network of interconnected channels in a unique manner. For example a section of the network of interconnected channels may be attributed to multiple different channels. Hence, rendering an indefinite or at least a large number of possibilities of defining the individual channels of the network of interconnected channels.

The design of the cooling element can be realized in a fine-granular manner based on the local heat generation rate of the respective element to be cooled, i.e. the element from which heat is to be dissipated.

In the present application, the another element from which heat is to be dissipated during use is also referred to as the cooled element or as the element to be cooled. Which means that the cooled element (or the element to be cooled) is, can or will be cooled by the cooling element during use. In one embodiment the element to be cooled may be a semiconductor device, i.e. an integrated circuit board (IC).

In one embodiment, the design of the cooling element, especially the provision of the fins of the first and/or second groups of fins and/or the design of the network of interconnected channels and/or the pattern according to which the fins of the groups of fins (such as the first group of fins and the second group of fins) are respectively arranged, is based on at least one local variation of a heat generation rate of at least one region, such as of at least two regions, of the element to be cooled. For this purpose, a heat map indicating at least implicitly or at least in regions the local variation of the heat generation rate of the element to be cooled may be created and evaluated for the design of the cooling element. For example, the heat map may also indicate the distribution of the heat sources of the element to be cooled. The heat sources may be for example a single or multiple chips provided within the device to be cooled, such as a semiconductor device.

In one embodiment, the design of the cooling element is alternatively or in addition based on a result of an evaluation of different structures, which especially have at least in part different heat generation rates during use, of the element to be cooled.

In one embodiment the cooling element may be a microfluidic cooling element.

Preferably, the superior volume, within which the network of interconnected channels is considered, is defined in an arbitrary way. However, it is preferred that the superior volume, within which the network of interconnected channels is considered, comprises at least one part of a global network of interconnected channels of the cooling element.

The superior volume may be defined as a volume of cuboid shape. The first volume may be defined as a volume of cuboid shape. The second volume may be defined as a volume of cuboid shape.

Since the cooling element being configured for heat-transferring contact with another element from which heat is to be dissipated during use, preferably heat can be dissipated from the another element, at least in a state in which the cooling element is in heat-transferring contact with the another element from which heat is to be dissipated during use.

The superior volume preferably is a joint volume of the first volume and the second volume. However, in some embodiments the superior volume may comprise in addition to the first volume and the second volume also one or more other volumes.

The first volume preferably is arbitrarily shaped. The first volume, for example, has the shape of a parallelepiped, especially a cube. The second volume preferably is arbitrarily shaped. The second volume, for example, has the shape of a parallelepiped, especially a cube. Preferably, the first volume and the second volume are of identical size.

It turns out that if for each section of at least one, preferably two or more, sections of the network of interconnected channels, two or more fins can be identified which contribute to the formation of the boundary of the respective section of the network of interconnected channels, a compact and efficient design of the cooling element is possible. Preferably, for each section two individual fins can be identified which contribute to the formation of the boundary of the respective section of the network of interconnected channels.

For example, the fins of the first group of fins may at least in part be positioned where a higher heat flu is present on the element to be cooled while the fins of the second group of fins may at least in part be positioned where a lower heat flu is present on the element to be cooled.

The cooling element may be designed as or may comprise a 2.5D architecture.

Preferably, the superior volume is defined.

Preferably, the first volume is defined.

Preferably, the second volume is defined.

Alternatively or in addition an embodiment can be provided in which the cooling element comprises at least one inlet of the network of interconnected channels for supplying the liquid cooling agent to the network of interconnected channels and/or at least one outlet of the network of interconnected channels for discharging the liquid cooling agent from the network of interconnected channels.

The inlet and/or the outlet allow in an efficient manner to manage the flow of the liquid cooling agent through the network of interconnected channels.

Alternatively or in addition an embodiment can be provided according to which in the first volume, in the second volume and/or in the superior volume, at least in a state in which the cooling element is in heat-transferring contact with the another element from which heat is to be dissipated during use, at least in regions the liquid cooling agent can flow, especially from the at least one inlet towards the at least one outlet, so that heat can be dissipated.

In that the liquid cooling agent can flow at least in regions in one or more of said volumes (especially at least in regions in the first volume, at least in regions in the second volume and/or at least in regions in the superior volume), an efficient exchange of liquid cooling agent can be enabled. Hence, liquid cooling agent which is heated from heat to be dissipated from the element to be cooled can be exchanged with fresh liquid cooling agent which is colder.

Alternatively or in addition an embodiment can be provided in which the fins of the **second group** of fins are arranged in a **regular pattern,** especially having a primitive geometry.

For example, a regular pattern of fins can mean that the fins are arranged periodically along a first direction and/or along a second direction angled or perpendicular to the first direction. The first and second directions both may be parallel to a plane which is parallel to a bottom surface of the cooling element. The first and second directions both may alternatively or in addition be perpendicular or arranged at a certain angle to a direction of main extension of the fins.

The fins of the second group of fins and/or the regular pattern, for example, may comprise or be designed as standard mesoscale structures.

Alternatively or in addition an embodiment can be provided in which the fins of the **first group** of fins are arranged in an **irregular pattern.**

The irregular pattern preferably is at least in part a result from an optimization process.

For example, an irregular pattern of fins can mean that the fins are arranged at least in part non-periodically along the first direction and/or along the second direction perpendicular to the first direction. The irregular pattern of fins can form a non-uniform, non-homogenous, non-straight, and/or irregular cooling structure configuration which differs from a cooling structure with only straight channels and channels known from conventional cooling structures with regular cooling structure patterns. In an irregular pattern of fins, at least one of the fin's width and orientation - or one of the width and orientation of the channels formed by the fins- can vary in direction of its length extension. At least one of the fins and/or channels formed can branch and/or ramify into at least one further fin/channel or multiple further fins/channels. The length extension here refers to the fin's/channel's overall length direction constituting the flow direction of the cooling agent guided through the cooling structure. A changing or varying orientation, thus, means that the fin/channel is not straight, but for example curved, kinked, and/or branched. Due to the configurational complexity of such non-uniform, non-homogenous, non-straight, and/or irregular pattern cooling efficiency can be improved.

The fins provided within the first volume, hence, may be regarded at least in some regions as an inhomogeneous cooling structure. For a preferred cooling element two or more such first volumes may be defined (each may have different patterns of fins of two first groups of fins) within which respective inhomogeneous cooling structures of identical or different design may be provided. Alternatively, or in addition, the cooling element may comprise at least one other volume (such as the second volume) within which a regular cooling structure (especially at least in part in form of the fins of the second group of fins) is provided. Preferably, the other volume within which a regular cooling structure is provided is adjacent to and/or in fluidal communication with the one or more first volumes.

The design of the fins (which might be regarded as cooling features) may comprise the first group of fins arranged in an irregular pattern which may be an optimized design (generated e.g. by an optimization software) and the second group of fins arranged in a regular pattern which may be standard features like straight fins forming straight channels and/or pin-fins. In a preferred embodiment, the optimized design region is situated where the heat-flux on the element to be cooled is higher (for example a SoC), while standard features can be used where the heat-flux on the element to be cooled is lower (for example an embedded memory). Both features may be provided on the same base element (which is described in more detail also below). The arrangement of the fins of the first and second groups of fins may be linked to a power map of the element to be cooled and therefore to its architecture.

This hybrid design base element may be bonded to a manifold, which acts as the interface with the external piping system, and also may create at least in part the required distribution of the fluid to the various parts of the design as required. In this sense, the manifold may also be an integral part of the cooling element. This is described in more detail also below.

A combination of fins arranged in an irregular pattern (e.g. optimized design cooling features in the first volume) and fins arranged in a regular pattern (e.g. standardized cooling features in the second volume) in one cooling element, which are linked to the architecture of the chip and the power map is particularly preferred.

A manifold that provides guidance to the various fins may also be provided and/or be comprised by the cooling element at least in part.

Alternatively or in addition an embodiment can be provided in which the fins of the **first group** of fins are arranged in a first **irregular pattern** and the fins of the **second group** of fins are arranged in a second **irregular pattern.**

This configuration of patterns allows to realize a particular efficient heat dissipation.

For example, the first irregular pattern and the second irregular pattern can i) be different, i.e. can have different channel structures with different heat dissipation rates, or ii) be similar, i.e. can have the same channel structures and the same heat dissipation, or ii) can be combinations of i) and ii).

Alternatively or in addition an embodiment can be provided in which the cooling element comprises at least one definable **third volume,** which third volume is free of fins, wherein preferably (i) the third volume is comprised by the superior volume and/or (ii) the superior volume is identical to a joint volume of the first, second and third volumes.

In that a zone, which is free of fins, is provided, surprisingly a particular efficient heat dissipation can be achieved with a respective designed cooling element.

The third volume preferably is arbitrarily shaped. The third volume, for example, has the shape of a parallelepiped, especially a cube. Preferably, the third volume has at least 10 % of the size of each of the first and/or second volume. Preferably, the third volume has at most 100 % of the size of each of the first and/or second volume, especially the third volume has the identical size than each of the first and/or second volume.

Preferably the third volume is defined.

Alternatively or in addition an embodiment can be provided in which the first volume and the third volume and/or the second volume and the third volume, respectively, are, preferably directly, adjacent to each other.

This arrangement allows to realize a particular efficient heat dissipation.

Alternatively or in addition an embodiment can be provided in which the third volume is arranged between, especially directly between, the first volume and the second volume, preferably the third volume is sandwiched between the first volume and the second volume.

If the zone which is free of fins separates the fins of the first and second groups of fins from each other, it turns out that efficiency of heat dissipation can be increased, what is very surprising.

Alternatively or in addition an embodiment can be provided in which the cooling element comprises at least one **base element** and wherein preferably the fins of the first group of fins are arranged on a **first surface area** of the base element and the fins of the second group of fins are arranged on a **second surface area** of the base element.

The base element for example may be made of copper.

For example, the base element may be brought in contact with the element to be cooled through a thermal interface material. Therefore, the cooling element, especially the base element, may comprise a respective thermal interface material.

The base element may be designed at least in some areas as a substrate and/or may comprise at least one substrate.

In one embodiment the base element is designed as a coldplate, especially a copper coldplate. For example, in one embodiment, the cooling element is about a microfluidics coldplate for electronics chips.

It is also possible that the cooling element comprises at least two base elements and wherein preferably the fins of the first group of fins are arranged on a surface area of a first base element (which surface area may be the above-mentioned first surface area) and the fins of the second group of fins are arranged on a surface area of the second base element (which surface area may be the above-mentioned second surface area).

In one embodiment each of the fins of the first group of fins is made in one piece with the base element, especially the first base element. In one embodiment each of the fins of the second group of fins is made in one piece with the base element, especially the second base element.

For example, an aspect ratio of 8-12, such as 10, may be used for the base element. For example, the smallest distance between two fins in each case of the first group of fins and second group of fins may be 50-100 um or even less.

Alternatively or in addition an embodiment can be provided according to which in at least one cross section of the superior volume lying within a cross-sectional plane of the cooling element, preferably in a defined area of at least 10 mm x 30 mm, all of the fins of the second group of fins have the same cross-sectional shape, and/or that in the cross section of the superior volume, preferably in a defined area of at least 25 mm x 35 mm, all of the fins of the first group of fins have a different cross-sectional shape to one another and preferably all of the fins of the second group of fins have a different cross-sectional shape to one another.

Choosing one of the mentioned design options of the fins allow to realize a particular high cooling efficiency.

Said cross-sectional plane of the cooling element in which the cross section lies may be a plane which extends parallel to at least two directions of flow of the liquid cooling agent within the network of interconnected channels. For example, a normal vector of the cross-sectional plane may be perpendicular to the main flow of the liquid cooling agent within the network of interconnected channels within the superior volume. For example, said cross-sectional plane of the cooling element may be a horizontal plane. Said cross-sectional plane preferably is parallel to a bottom surface of the cooling element which surface especially is or can be attached to the element to be cooled.

Alternatively or in addition an embodiment can be provided according to which in the cross section of the superior volume, preferably in a defined area of at least 10 mm x 30 mm, each of the fins of the second group of fins has a ring-like and/or hexagonal and/or octagonal cross-sectional shape, wherein preferably the cross-sectional plane extends parallel to the first and/or second surface areas of the base element.

Respective shapes of the fins allow to establish a particular efficient flow of the liquid cooling agent through the network of interconnected channels. Furthermore, it is possible to produce fins having such shapes in a particular reliable and efficient manner.

Alternatively or in addition an embodiment can be provided according to which in the cross section of the superior volume, preferably in a defined area of at least 10 mm x 30 mm or of at least 25 mm x 35 mm, less than 5 % of, preferably less than 3 % of, more preferably none of, the fins in each case of the first group of fins and/or the second group of fins have a ring-like and/or disk-like cross-sectional shape.

These options may be part of a constraint during a simulation of the cooling element and/or an optimization process of the cooling element.

Within this application, the expression "the fins in each case of the first group of fins and/or the second group of fins fulfill limitation X" means that the respective limitation X applies to the fins within the same group of fins but not necessarily to fins across different groups of fins. For example, if both groups of fins are considered ("and" conjunction) the limitation applies to the fins of the first group of fins and the limitation applies to the fins of the second group of fins. For example, if only one groups of fins is considered ("or" conjunction) the limitation applies to the fins of the first group of fins or the limitation applies to the fins of the second group of fins, dependent on which group is considered. Even if the limitation applies only to one group ("or" conjunction), it is left open weather or not the other group also fulfills this limitation, unless stated otherwise.

Alternatively or in addition an embodiment can be provided in which the first volume and the second volume are, preferably directly, adjacent to each other, and preferably the superior volume is identical to a joint volume of the first and second volumes.

This is a particular preferred arrangement of the volumes which can be used e.g. in a simulation process efficiently.

Alternatively or in addition an embodiment can be provided in which the cooling element comprises at least two **second groups of fins** each second group of fins arranged within one of at least two definable **second volumes,** wherein the at least one first volume is arranged between, especially directly between, at least two of the at least two second volumes, preferably the at least one first volume is sandwiched between at least two of the second volumes.

For example, the fins of a first second group of fins (which is one of the at least two second groups) are arranged in a regular pattern and the fins of a second second group of fins (which is the other one of the at least two second groups) are arranged in a regular pattern (the two regular patterns may be identical or different). Optionally, the fins of the first group of fins are arranged in an irregular pattern. Hence, it is preferred that the first volume (with the fins of the first group of fins) is sandwiched between the first second volume (with the fins of the first second group of fins) and the second second volume (with the fins of the second second group of fins).

Preferably the second volumes are defined.

Alternatively or in addition an embodiment can be provided in which at least the fins of the **first group** of fins contribute at least in part to the formation of boundaries of the channels of at least one **first part** of the network of interconnected channels and **wherein** at least the fins of the **second group** of fins contribute at least in part to the formation of boundaries of the channels of at least one **second part** of the network of interconnected channels.

Hence, the network of interconnected channels may be regarded as having two or even more parts. The different parts may be realized by different single units. The different parts may be designed by different optimization processes. The design of one of the first and second parts may be at least in part a result of an optimization processes, especially in form of an irregular pattern, while the respective other part may have a regular pattern and/or has a conventional design.

Alternatively or in addition an embodiment can be provided in which during use of the cooling element a heat dissipation rate of the first part of the network of interconnected channels is different, especially higher, than a heat dissipation rate of the second part of the network of interconnected channels.

This way different structures of the element to be cooled having different heat generation rates can be taken into account.

Alternatively or in addition an embodiment can be provided in which the first part of the network of interconnected channels and the second part of the network of interconnected channels are designed in such a way so as to dissipate different amounts of heat from different regions of the element to be cooled during use of the cooling element, especially the first part of the network of interconnected channels is designed compared to the second part of the network of interconnected channels so as to dissipate a larger amount of heat from the element to be cooled, for example at least 3 times, at least 5 times or at least 10 times of the heat.

This way different regions of the element to be cooled having different heat generation rates can be taken into account. For example, the first part of the network of interconnected channels may be used to dissipate heat away from a first region of the element to be cooled and the second part of the network of interconnected channels may be used to dissipate heat away from a second region of the element to be cooled, wherein the heat generation rate of the first region of the element to be cooled is higher than the heat generation rate of the second region of the element to be cooled.

A "region" of the element to be cooled may have a spatial extension along three dimensions. In a "region" of the element to be cooled the heat to be dissipated can be produced (e.g. by structures located in that region) and/or otherwise accumulated (e.g. in that heat flows from other parts of the element to be cooled to that region, especially along a heat gradient).

For example, the first part of the network of interconnected channels may be designed such that during use a heat of 400-1000 Watts (such as 1000 Watts) can be dissipated away from the first region of the element to be cooled during use. For example, the second part of the network of interconnected channels may be designed such that that during use a heat of 150-200 Watts (such as 200 Watts) can be dissipated away from the second region of the element to be cooled during use.

Alternatively or in addition an embodiment can be provided in which the first part of the network of interconnected channels and the second part of the network of interconnected channels can be linked to regions of the element to be cooled which have different heat generation rates, especially the first part of the network of interconnected channels can be linked to a first region of the element to be cooled which has a higher heat generation rate than a second region of the element to be cooled to which the second part of the network of interconnected channels can be linked.

This is particularly preferred. "Linking" a part of the network of interconnected channels to a region of the element to be cooled may be accomplished in that the cooling element is brought in a heat-transferring contact with the element to be cooled.

Alternatively or in addition an embodiment can be provided in which the cooling element comprises at least one cover element for covering the base element during use of the cooling element at least in some areas, wherein preferably the cover element and the base element are directly bonded, especially via thermocompression, and/or brazed to each other and/or wherein at least one sealing element, such as an O-ring, is arranged between the cover element and the base element.

The cover element allows to produce a closed cooling element so that the liquid cooling agent can be guided in a particular controlled manner through the superior volume, which is particularly preferred.

The cover element may preferably be designed such to guide at least in part the liquid cooling agent towards the network of interconnected channels and/or away from it.

In one embodiment, the cover element is bonded to the base element through thermocompression Cu direct bonding or brazing.

Alternatively or in addition an embodiment can be provided in which the cover element comprises at least one recess, preferably at least two recesses, wherein
a fluidical connection between the network of interconnected channels, especially the **first part** of the network of interconnected channels, and an environment of the cooling element is provided at least in part via a **first recess** of the at least one recess, which first recess preferably forms part of the at least one outlet and/or which is fluidically connected to the at least one outlet,
   and/or
a fluidical connection between the network of interconnected channels, especially the **second part** of the network of interconnected channels, and an environment of the cooling element is provided at least in part via a **second recess** of the at least one recess, which second recess preferably forms part of the at least one inlet and/or which is fluidically connected to the at least one inlet.

The cover element, thus, may preferably be utilized for providing connection capabilities for guiding means for guiding the liquid cooling agent. This allows a particular compact design.

The cover element may provide one or more connection means for connecting guiding means for guiding the liquid cooling agent from or to the first recess.

The cover element may provide one or more connection means for connecting guiding means for guiding the liquid cooling agent from or to the second recess.

Alternatively or in addition an embodiment can be provided in which the first and/or second recess/es is/are formed as through holes arranged in the cover element.

This can be realized in an easy and efficient manner.

Alternatively or in addition an embodiment can be provided in which the cooling element comprises at least one **top element** which is or can be brought in contact with the cover element, and
wherein preferably the top element comprises one or more, preferably integrally designed, manifolds, which manifolds preferably provide at least parts of, respectively, the inlet and/or outlet and/or cooperate with the at least one recess of the cover element, especially with the first and second recesses,
wherein preferably the top element comprises means for connecting the manifolds to external piping and/or to external connection means for supplying the liquid cooling agent to the inlet and discharging the liquid cooling agent away from the outlet.

This is a preferred design option, since the top element may comprise all or at least some of the connection means which are necessary in order to connect the cooling element to a source and/or sink of the liquid cooling agent.

Alternatively or in addition an embodiment can be provided in which the cover element and the top element are directly bonded and/or brazed to each other and/or wherein at least one sealing element, such as an O-ring, is arranged between the cover element and the top element.

This way the cooling element can be produced in an easy and efficient manner.

For example, the top element is sealed to the cover element through one or more O-rings.

Alternatively or in addition an embodiment can be provided in which the cover element and/or the top element, respectively, is made of copper and/or is CNC machined.

This way the elements can be produced in an easy and efficient manner.

Alternatively or in addition an embodiment can be provided in which the cover element and the top element are designed in one piece.

This way the joint element can be produced in an easy and efficient manner.

Alternatively or in addition an embodiment can be provided in which the base element is made of copper and/or a 3D printed structure.

This way the element can be produced in an easy and efficient manner.

Alternatively or in addition an embodiment can be provided in which the base element is a **single piece** and/or wherein the fins of the first and/or second group of fins are integrally built with the base element.

In line with the discussion above, preferably, the fins of the first group of fins are integrally built with a first base element and/or the fins of the second group of fins are integrally built with a second base element.

Alternatively or in addition an embodiment can be provided in which the cover element, especially an inner surface of the cover element, contributes to the formation of boundaries of the channels of the network of interconnected channels at least in part in an assembled state of the cooling element.

Alternatively or in addition the base element, especially a surface of the base element, contributes to the formation of boundaries of the channels of the network of interconnected channels at least in part in an assembled state of the cooling element.

Alternatively or in addition an embodiment can be provided in which the first volume is of cuboidal shape and all fins of the cooling element which are arranged within the first volume are fins of the first group of fins and/or the second volume is of cuboidal shape and all fins of the cooling element which are arranged within the second volume are fins of the second group of fins.

Likewise, the first second volume can be of cuboidal shape and all fins of the cooling element which are arranged within the first second volume are fins of the first second group of fins and/or the second second volume can be of cuboidal shape and all fins of the cooling element which are arranged within the second second volume are fins of the second second group of fins

Alternatively or in addition an embodiment can be provided according to which (i) in each of the first and second groups of fins the number of fins is larger than 10; (ii) among the fins in each case of the first group of fins and/or the second group of fins there are at least 10 fins which in at least one cross-sectional plane of the cooling element have different cross-sectional shapes; (iii) all fins of the second group of fins have in the cross-sectional plane of the cooling element identical cross-sectional shapes; (iv) the fins of the first group of fins are at least in part unevenly distributed within the first volume; (v) the fins of the second group of fins are at least in part unevenly distributed within the second volume; (vi) the fins of the second group of fins are evenly distributed within the second volume; and/or (vii) for each section of at least one, preferably two or more, sections of the first and/or second part of the network of interconnected channels, two or more fins of the first and/or second group of fins can be identified which contribute to the formation of the boundary of the respective section of the first and/or second part of the network of interconnected channels.

If the number of fins in the first volume is larger than 10, the flow of the liquid cooling agent can be controlled in a preferred manner, hence, a particular high cooling efficiency can be obtained. If the number of fins in the second volume is larger than 10, the flow of the liquid cooling agent can be controlled in a preferred manner, hence, a particular high cooling efficiency can be obtained.

If there are at least two, preferably at least 10, fins in each case of the first and/or second groups of fins and/or across the first and second groups of fins which in at least one cross-sectional plane of the cooling element have different cross-sectional shapes, a particular high cooling efficiency can be obtained. Said cross-sectional plane of the cooling element may be a plane which extends parallel to at least two directions of flow of the liquid cooling agent within the network of interconnected channels. For example, said cross-sectional plane of the cooling element may be a horizontal plane. Said cross-sectional plane preferably is parallel to a bottom surface of the cooling element which especially is or can be attached to the element to be cooled. Said cross-sectional plane of the cooling element may be parallel to the above-mentioned first and second directions.

If the fins are at least in part unevenly distributed within the first volume, a particular efficient flow of the liquid cooling agent is possible. If the fins are at least in part unevenly distributed within the second volume, a particular efficient flow of the liquid cooling agent is possible. However, it turned out that it may also be advantageous if the fins are evenly distributed within the second volume to improve the cooling efficiency.

Alternatively or in addition an embodiment can be provided according to which in the cross section of the superior volume for each fin of the first and second group of fins which lies within the cross section, hence being a specific fin, a perimeter can be associated with the respective specific fin,
wherein for each specific fin a perimeter parameter *Pₑ* can be defined which takes the value of the length of its associated perimeter,
and wherein preferably for each specific fin a surface can be associated with the respective specific fin, the surface being an area enclosed by the perimeter associated with the respective specific fin,
wherein for each specific fin a surface parameter *Sₑ* can be defined which takes the value of the area of its associated surface.

It turns out that the perimeter parameter is a variable which can be used to describe the design of the cooling element in a preferred manner. Also, the perimeter parameter can be used for the definition of further variables which in turn describe the design of the cooling element in a preferred manner.

As described above (especially with respect to the cross-sectional shapes of the fins), the cross section of the superior volume which is considered here is the at least one cross section of the superior volume lying within the cross-sectional plane of the cooling element. It Is not necessary that the limitations described above in the context of the cross section apply.

It is noted that the cross section here is a cross section of the superior volume only and, hence, does not comprise any structures residing outside of the superior volume.

Obtaining a perimeter parameter for an individual specific fin (for example during the design process of a cooling element and/or during verification/review of an existing cooling element) is easily possible. For example, within the cross section a length of the perimeter of that specific fin can be determined. The length (e.g. value X) is then the value the perimeter parameter of that specific fin takes for that specific fin.

Preferably, the perimeter of a specific fin is a cutting line between a surface, such as an outer surface, especially a side surface, of the respective specific fin and the cross-sectional plane.

Preferably, the perimeter is a contour of the respective specific fin in the cross section. For example, the contour refers to an outer contour of the respective specific fin in the cross section. For a specific fin which is at least in some regions hollow with a hollow portion lying within the cross section, there may be an outer contour (especially exactly one outer counter) and at least one inner contour.

Preferably, the perimeter alternatively or in addition is a closed perimeter of the respective specific fin in the cross section. In case that a specific fin is only in parts contained within the superior volume, the end points of the perimeter within the cross section may be directly connected with each other, so as to form a closed perimeter within the cross section and that perimeter may then be regarded as the closed perimeter of the respective specific fin.

For example, the perimeter of a specific fin is an outer and/or closed perimeter of the specific fin in the cross section.

Preferably, if the perimeter is defined as the cutting line between a surface of the respective specific fin and the cross-sectional plane, the entire surface (especially the entire outer surface) of the specific fin is considered for this purpose.

It turns out that the surface parameter is a variable which can be used to describe the design of the cooling element in a preferred manner.

It is noted that, since the perimeter is within the cross section, also the surface is an area within the cross section.

Obtaining a surface parameter for an individual specific fin (for example during the design process of a cooling element and/or during verification/review of an existing cooling element) is easily possible. For example, once the perimeter of the specific fin is determined, the area enclosed within that perimeter can be determined which is the surface. The area (e.g. value X) is then the value the surface parameter of that specific fin takes for that specific fin.

Preferably, the surface refers to a fully filled area enclosed by the perimeter. For example, for a specific fin which is at least in some regions hollow with a hollow portion lying within the cross section, the area of the surface also covers the hollow portion lying within the cross section.

In case that a specific fin is only in parts contained within the superior volume, the area of the surface reaches until the border of the superior volume.

Thus, a process of designing a preferred cooling element may incorporate adjusting the perimeters of the specific fins such that the perimeter parameters and/or surface parameters of the specific fins fulfill one or more constraints, as will be described below in more detail.

Alternatively or in addition an embodiment can be provided in which for each specific fin an equivalent-diameter parameter ${D}_{e} = 2 \sqrt{{S}_{e} / π}$, with *Sₑ* being the surface parameter of the respective specific fin, can be defined,
wherein preferably for the specific fins in each case of the first group of fins and/or the second group of fins:
- each equivalent-diameter parameter *Dₑ* has a value between 1 µm and 1500 µm, especially between 7 µm and 1300 µm,
- the mean value of the equivalent-diameter parameters of the respective specific fins of the first group of fins and/or the second group of fins is between 100 µm and 700 µm, especially between 150 µm and 500 µm,
- the median value of the equivalent-diameter parameters of the respective specific fins of the first group of fins and/or the second group of fins is between 150 µm and 700 µm, especially between 177 µm and 447 µm,
- the mode value of the equivalent-diameter parameters of the respective specific fins of the first group of fins and/or the second group of fins is between 150 µm and 600 µm, especially between 171 µm and 485 µm, and/or

- the standard deviation of the equivalent-diameter parameters of the respective specific fins of the first group of fins and/or the second group of fins is between 30 µm and 350 µm, especially between 50 µm and 200 µm, and/or is between ¼ and ½ of the mean value of the equivalent-diameter parameters of the specific fins.

It turns out that the equivalent-diameter parameter is a variable which can be used to describe the design of the cooling element in a preferred manner.

Obtaining an equivalent-diameter parameter for an individual specific fin (for example during the design process of a cooling element and/or during verification/review of an existing cooling element) is easily possible. For example, once the surface parameter of that specific fin has been determined, also the equivalent-diameter parameter can be determined in a straight-forward manner for that specific fin. The outcome of the right-hand side of the equation (e.g. value X) is then the value the equivalent-diameter parameter of that specific fin takes for that specific fin.

Cooling elements for which the equivalent-diameter parameters of all specific fins in each case of the first group of fins and/or the second group of fins (see above for an explanation of the term "in each case ..." which still apply here and in the following, too) have one or more statistical variables (especially the mean value, the median value, the mode value and/or the standard deviation) respectively taking values within the limits stated above surprisingly turn out to have a particularly high cooling efficiency. Of course, for the respective statistical variables the equivalent-diameter parameters of all specific fins are considered.

The equivalent-diameter parameters of all specific fins in each case of the first group of fins and/or the second group of fins of a preferred cooling element, therefore, fulfill one or more of the respective statistical variables. Hence, a preferred cooling element fulfills one or more of the statistical variables. Again, if two groups of fins are considered, then the fins of each group fulfill the respective limitation.

Thus, a process of designing a preferred cooling element may incorporate adjusting the perimeters of the specific fins in each case of the first group of fins and/or the second group of fins such that ultimately the equivalent-diameter parameters of the specific fins in each case of the first group of fins and/or the second group of fins fulfill one or more of the respective statistical variables.

Alternatively or in addition an embodiment can be provided in which
- the mean values of the equivalent-diameter parameters of the specific fins, respectively, of the first group of fins and the second group of fins, differ by at least 1 % and/or at most 100 %,
- the median values of the equivalent-diameter parameters of the specific fins, respectively, of the first group of fins and the second group of fins, differ by at least 1 % and/or at most 100 %,
- the mode values of the equivalent-diameter parameters of the specific fins, respectively, of the first group of fins and the second group of fins, differ by at least 1 % and/or at most 100 %,
   and/or
- the standard deviations of the equivalent-diameter parameters of the specific fins, respectively, of the first group of fins and the second group of fins, differ by at least 1 % and/or at most 100 %.

In other words, the variables of the fins of the two groups of fins are compared with each other.

Alternatively or in addition an embodiment can be provided according to which in each case of the first group of fins and/or the second group of fins a histogram of the equivalent-diameter parameters of the respective specific fins of the first group of fins and/or the second group of fins can be determined and each of which histograms follows a normal distribution, especially having a skewness between 0 and 2, especially between 0 and 1.7, preferably the two histograms have a different skewness by at least 1 % and/or at most 100 %, and/or a histogram of the equivalent-diameter parameters of the specific fins of the second group of fins can be determined and which histogram follows a normal distribution, especially having a skewness between 0 and 2, especially between 0 and 1.7.

A cooling element with specific fins in each case of the first group of fins and/or the second group of fins, the equivalent-diameter parameters of which result in a histogram of respective type of distribution and/or having a respective skewness turn out to have a particularly high cooling efficiency. For the histogram, of course, the equivalent-diameter parameters of all specific fins of the respective first and/or second group of fins are considered.

Thus, a process of designing a preferred cooling element may incorporate adjusting the perimeters of the specific fins in each case of the first group of fins and/or the second group of fins such that the histogram of the equivalent-diameter parameters of the specific fins in each case of the first group of fins and/or the second group of fins is of the respective type of distribution and/or has the respective skewness.

Preferably, each histogram and/or distribution has a mean value, a median value, a mode value and/or a standard deviation as stated above for the equivalent-diameter parameters.

If the specific fins of both groups of fins are considered, they preferably can be designed such that the two respective histograms fulfill the stated limitation.

Alternatively or in addition an embodiment can be provided in which for each specific fin a roundness parameter $σ = 4 π \frac{{S}_{e}}{{P}_{e}^{2}}$, with *Pₑ* being the perimeter parameter and *Sₑ* being the surface parameter, respectively, of the respective specific fin, can be defined,
wherein preferably for the specific fins in each case of the first group of fins and/or the second group of fins:
- each roundness parameter σ has a value between 0.00 and 1.0, especially between 0.0 and 0.86,
- the mean value of the roundness parameters of the respective specific fins of the first group of fins and/or the second group of fins is between 0.2 and 0.7, especially between 0.34 and 0.61,
- the median value of the roundness parameters of the respective specific fins of the first group of fins and/or the second group of fins is between 0.2 and 0.8, especially between 0.31 and 0.65,
- the mode value of the roundness parameters of the respective specific fins of the first group of fins and/or the second group of fins is between 0.1 and 0.8, especially between 0.2 and 0.69, and/or

- the standard deviation of the roundness parameters of the respective specific fins of the first group of fins and/or the second group of fins is between 0.1 and 0.3, especially between 0.1 and 0.2.

It turns out that the roundness parameter is a variable which can be used to describe the design of the cooling element in a preferred manner.

The roundness parameter (in the present 2D representation) is one (1) for a perfect circle and goes down as far as zero (0) for highly non-circular shapes. Hence, the roundness parameter takes values between and inclusive of 0 and 1.

Obtaining a roundness parameter for an individual specific fin (for example during the design process of a cooling element and/or during verification/review of an existing cooling element) is easily possible. For example, once the perimeter parameter and the surface parameter of that specific fin have been determined, also the roundness parameter can be determined in a straight-forward manner for that specific fin. The outcome of the right-hand side of the equation (e.g. value X) is then the value the roundness parameter of that specific fin takes for that specific fin.

Cooling elements for which the roundness parameters of all specific fins in each case of the first group of fins and/or the second group of fins have one or more statistical variables (especially the mean value, the median value, the mode value and/or the standard deviation) respectively taking values within the limits stated above surprisingly turn out to have a particularly high cooling efficiency. Of course, for the respective statistical variables the roundness parameters of all specific fins are considered.

The roundness parameters of all specific fins in each case of the first group of fins and/or the second group of fins of a preferred cooling element, therefore, fulfill one or more of the respective statistical variables. Hence, a preferred cooling element fulfills one or more of the statistical variables. Again, if two groups of fins are considered, then the fins of each group fulfill the respective limitation.

Thus, a process of designing a preferred cooling element may incorporate adjusting the perimeters of the specific fins in each case of the first group of fins and/or the second group of fins such that ultimately the roundness parameters of the specific fins in each case of the first group of fins and/or the second group of fins fulfill one or more of the respective statistical variables.

Alternatively or in addition an embodiment can be provided in which
- the mean values of the roundness parameters of the specific fins, respectively, of the first group of fins and the second group of fins, differ by at least 1 % and/or at most 100 %,
- the median values of the roundness parameters of the specific fins, respectively, of the first group of fins and the second group of fins, differ by at least 1 % and/or at most 100 %,
- the mode values of the roundness parameters of the specific fins, respectively, of the first group of fins and the second group of fins, differ by at least 1 % and/or at most 100 %,
   and/or

- the standard deviations of the roundness parameters of the specific fins, respectively, of the first group of fins and the second group of fins, differ by at least 1 % and/or at most 100 %.

In other words, the variables of the fins of the two groups of fins are compared with each other.

Alternatively or in addition an embodiment can be provided according to which in each case of the first group of fins and/or the second group of fins a histogram of the roundness parameters of the respective specific fins of the first group of fins and/or the second group of fins can be determined and each of which histograms follows a beta distribution, especially having a skewness between -1.3 and 1.5, especially between 0.25 and 0.5, between 0.5 and 1.5 or between -1.2 and -0.05, preferably the two histograms have a different skewness by at least 1 % and/or at most 100 %, and/or a histogram of the roundness parameters of the specific fins of the second group of fins can be determined and which histogram follows a beta distribution, especially having a skewness between -1.3 and 1.5, especially between 0.25 and 0.5, between 0.5 and 1.5 or between -1.2 and -0.05.

A cooling element with specific fins fins in each case of the first group of fins and/or the second group of fins, the roundness parameters of which result in a histogram of respective type of distribution and/or having a respective skewness turn out to have a particularly high cooling efficiency. For the histogram, of course, the roundness parameters of all specific fins of the respective first and/or second group of fins are considered.

Thus, a process of designing a preferred cooling element may incorporate adjusting the perimeters of the specific fins in each case of the first group of fins and/or the second group of fins such that the histogram of the roundness parameters of the specific fins in each case of the first group of fins and/or the second group of fins is of the respective type of distribution and/or has the respective skewness.

Preferably, each histogram and/or distribution has a mean value, a median value, a mode value and/or a standard deviation as stated above for the roundness parameters.

If the specific fins of both groups of fins are considered, they preferably can be designed such that the two respective histograms fulfill the stated limitation

Alternatively or in addition an embodiment can be provided in which for each specific fin a mean-diameter parameter ${d}_{32} = 4 \frac{{S}_{e}}{{P}_{e}}$, with *Pₑ* being the perimeter parameter and *Sₑ* being the surface parameter, respectively, of the respective specific fin, can be defined,
wherein preferably for the specific fins in each case of the first group of fins and/or the second group of fins:
- each mean-diameter parameter *d*₃₂ has a value between 3 µm and 800 µm, especially between 7 µm and 685 µm,
- the mean value of the mean-diameter parameters of the respective specific fins of the first group of fins and/or the second group of fins is between 100 µm and 350 µm, especially between 125 µm and 295 µm,
- the median value of the mean-diameter parameters of the respective specific fins of the first group of fins and/or the second group of fins is between 100 µm and 400 µm, especially between 127 µm and 300 µm,
- the mode value of the mean-diameter parameters of the respective specific fins of the first group of fins and/or the second group of fins is between 100 µm and 400 µm, especially between 130 µm and 300 µm, and/or

- the standard deviation of the mean-diameter parameters of the respective specific fins of the first group of fins and/or the second group of fins is between 20 µm and 200 µm, especially between 30 µm and 80 µm, and/or is between ¼ and ½ of the mean value of the mean-diameter parameters of the specific fins.

It turns out that the mean-diameter parameter *d*₃₂ is a variable which can be used to describe the design of the cooling element in a preferred manner.

Obtaining a mean-diameter parameter *d*₃₂ for an individual specific fin (for example during the design process of a cooling element and/or during verification/review of an existing cooling element) is easily possible. For example, once the perimeter parameter and the surface parameter of that specific fin have been determined, also the mean-diameter parameter *d*₃₂ can be determined in a straight-forward manner for that specific fin. The outcome of the right-hand side of the equation (e.g. value X) is then the value the mean-diameter parameter *d*₃₂ of that specific fin takes for that specific fin.

Cooling elements for which the mean-diameter parameters *d*₃₂ of all specific fins in each case of the first group of fins and/or the second group of fins have one or more statistical variables (especially the mean value, the median value, the mode value and/or the standard deviation) respectively taking values within the limits stated above surprisingly turn out to have a particularly high cooling efficiency. Of course, for the respective statistical variables the mean-diameter parameters *d*₃₂ of all specific fins are considered.

The mean-diameter parameters *d*₃₂ of all specific fins in each case of the first group of fins and/or the second group of fins of a preferred cooling element, therefore, fulfill one or more of the respective statistical variables. Hence, a preferred cooling element fulfills one or more of the statistical variables. Again, if two groups of fins are considered, then the fins of each group fulfill the respective limitation.

Thus, a process of designing a preferred cooling element may incorporate adjusting the perimeters of the specific fins in each case of the first group of fins and/or the second group of fins such that ultimately the mean-diameter parameters *d*₃₂ of the specific fins in each case of the first group of fins and/or the second group of fins fulfill one or more of the respective statistical variables.

Alternatively or in addition an embodiment can be provided in which
- the mean values of the mean-diameter parameters of the specific fins, respectively, of the first group of fins and the second group of fins, differ by at least 1 % and/or at most 100 %,
- the median values of the mean-diameter parameters of the specific fins, respectively, of the first group of fins and the second group of fins, differ by at least 1 % and/or at most 100 %,
- the mode values of the mean-diameter parameters of the specific fins, respectively, of the first group of fins and the second group of fins, differ by at least 1 % and/or at most 100 %,
   and/or
- the standard deviations of the mean-diameter parameters of the specific fins, respectively, of the first group of fins and the second group of fins, differ by at least 1 % and/or at most 100 %.

In other words, the variables of the fins of the two groups of fins are compared with each other.

Alternatively or in addition an embodiment can be provided according to which in each case of the first group of fins and/or the second group of fins a histogram of the mean-diameter parameters of the respective specific fins of the first group of fins and/or the second group of fins can be determined and each of which histograms follows a normal distribution, especially having a skewness between -0.4 and 0.8, especially between 0.2 and 0.8 or between -0.3 and 0.1, preferably the two histograms have a different skewness by at least 1 % and/or at most 100 %, and/or a histogram of the mean-diameter parameters of the specific fins of the second group of fins can be determined and which histogram follows a normal distribution, especially having a skewness between -0.4 and 0.8, especially between 0.2 and 0.8 or between -0.3 and 0.1.

A cooling element with specific fins in each case of the first group of fins and/or the second group of fins, the mean-diameter parameters *d*₃₂ of which result in a histogram of respective type of distribution and/or having a respective skewness turn out to have a particularly high cooling efficiency. For the histogram, of course, the mean-diameter parameters *d*₃₂ of all specific fins of the respective first and/or second group of fins are considered.

Thus, a process of designing a preferred cooling element may incorporate adjusting the perimeters of the specific fins in each case of the first group of fins and/or the second group of fins such that the histogram of the mean-diameter parameters *d*₃₂ of the specific fins in each case of the first group of fins and/or the second group of fins is of the respective type of distribution and/or has the respective skewness.

Preferably, each histogram and/or distribution has a mean value, a median value, a mode value and/or a standard deviation as stated above for the mean-diameter parameters.

If the specific fins of both groups of fins are considered, they preferably can be designed such that the two respective histograms fulfill the stated limitation.

Alternatively or in addition an embodiment can be provided in which a pixelized representation of the cross section, with the pixels of the pixelized representation having the value 1 for pixels of the perimeters of the specific fins and having the value 0 otherwise, can be provided,
wherein a density parameter *ρₘ* can be defined which for each pixel within at least one region of the pixelized representation takes the value of a 2D moving average filter with its kernel centered at the respective pixel of the pixelized representation,
and preferably the value of which is the ratio of the sum of the values of the pixels within a specific area of the pixelized representation which is an area of the pixelized representation which is covered by the kernel centered at the respective pixel of the pixelized representation multiplied with a predefined average length associated with a single pixel to the number of pixels of the kernel multiplied with the square of the predefined average length,
wherein preferably one or more, preferably all, specific fins of the first group of fins are within at least one first area of the at least one region of the pixelized representation and/or one or more, preferably all, specific fins of the second group of fins are within at least one second area of the at least one region of the pixelized representation, which second area is different to and/or has no overlap with the first area,
wherein preferably for the pixels in each case of the first area and/or the second area:
   - each density parameter *ρₘ* has a value between 0 / mm and 30 / mm, especially between 0 / mm and 12 / mm,
   - the mean value of the density parameters of all respective pixels within the first area and/or second area of the pixelized representation is between 3 / mm and 10 / mm, especially between 4 / mm and 7 / mm,
   - the median value of the density parameters of all respective pixels within the first area and/or second area of the pixelized representation is between 3 / mm and 10 / mm, especially between 4 / mm and 7 / mm,
   - the mode value of the density parameters of all respective pixels within the first area and/or second area of the pixelized representation is between 3 / mm and 8 / mm, especially between 4.17 /mm and 7.36 /mm, and/or
   - the standard deviation of the density parameters of all respective pixels within the first area and/or second area of the pixelized representation is between 0.5 / mm and 5 / mm, especially between 0.95 / mm and 1.57 / mm.

It turns out that the density parameter is a variable which can be used to describe the design of the cooling element in a preferred manner.

The density parameter can be understood as a measure for how densely packed the fins in each case of the first area and/or the second area are locally in the design of the cooling element, particularly in the design of the superior volume of the cooling element. In Other words, the density parameter may indicate a density of the perimeters of the specific fins in each case of the first group of fins (via the first area) and/or the second group of fins (via the second area). Or in again other words, the density parameter can be understood as a measure of how much perimeter of the specific fins in each case of the first group of fins (via the first area) and/or the second group of fins (via the second area) is packed into a unit area of the kernel (hence, the perimeter parameter's unit is an inverse length).

Obtaining a density parameter for an individual pixel within the at least one region is easily possible, as described below in more detail.

For example, the perimeters of the specific fins may have a width of 1 pixel in the pixelized representation. Hence, the pixelized representation may be obtained in that the perimeters (as defined above) are set to the respective width.

For example, the pixelized representation may be a rectangular pattern of pixels which have N_{CP} columns of pixels and N_{RP} rows of pixels. The number of columns and the number of rows can be equal or different. Defining of the number of columns and the number of rows, hence the number of pixels, respectively, of the pixelized representation may be conducted as follows: For example, a minimum feature size is either predefined for a new design of a cooling element (e.g. for the purpose of designing a new cooling element) or is determined based on an existing design of a cooling element (e.g. for the purpose of evaluating that existing cooling element). The minimum feature size may refer to the minimum distance between adjacent fins (especially across the first and second group of fins). In other words, the minimum feature size may refer to the minimum width of the channels of the network of interconnected channels. In the case of design generation of the cooling element or parts thereof (especially the arrangement of the fins) via topology optimization, the minimum feature size may be an input from a user to the design algorithm that preferably acts as a low pass filter. For example, in topology optimization, the concept of a minimum feature size can be or is used for ensuring the manufacturability and structural integrity of the optimized design. When a minimum feature size in topology optimization is specified, basically the algorithm will generate a design where all channels of the network of interconnected channels are larger than or equal to this specified minimum feature size. The minimum feature size for example may be predefined or determined as being between 1 µm and 100 µm, such as 1 µm, 10 µm, 30 µm, 50 µm, 70 µm or 100 µm. The number of pixels of the pixelized representation (particularly its number of rows of pixels and its number of columns of pixels) can then be set such that there are a specific number of pixels (e.g. 100 pixels, 300 pixels, 500 pixels or 1000 pixels) per minimum feature size along the two main directions X and Y of the cross section. If for example the minimum feature size is 10 µm, the specific number of pixels is 100 and, both, the width and the height, respectively, of the cross section is 1.5 mm (i.e. 1,500 µm), then the pixelized representation may have N_{RP} = 15,000 rows of pixels and N_{CP} = 15,000 columns of pixels (1,500 µm x 100 pixels/ 10 µm).

Preferably, the predefined average length associated with a single pixel may be obtained based on the minimum feature size and the specific number of pixels as the ratio of the minimum feature size to the specific number of pixels. Hence, the predefined average length associated with a single pixel in combination with the dimensions of the cross section (which preferably is known) may be used to determine the resolution of the pixelized representation (i.e. the number of pixels in both directions X and Y as described above with the number of rows and columns).

This way it is possible to obtain the pixelized representation of the cross section such that it has an adequate resolution so that there is no or no significant loss of information. This way it is possible that the statistics of the design obtained based at least in part on the pixelized representation converge in a sufficient manner to the actual/real statistics of a given design.

For example, the kernel may be a rectangular pattern of pixels (which may have all the value one (1)) which may cover N_{CK} columns and N_{RK} rows of pixels of the pixelized representation, when both are overlayed. The number of columns and the number of rows can be equal or different. The size of the kernel may be determined such, that N_{CP} = 6..15 x N_{CK} and N_{RP} = 6..15 x N_{RK}, i.e. N_{CK} = N_{CP}/(6..15) and N_{RK} = N_{RP}/(6..15). This means that for the kernel the number of columns of pixels (N_{CK}) is equal to the number of columns of pixels of the pixelized representation (N_{CP}) divided by a number between 6 and 15 and the number of rows of pixels (N_{RK}) is equal to the number of rows of pixels of the pixelized representation (N_{RP}) divided by a number between 6 and 15. In both cases the number between 6 and 15 may be for example 6, 10 or 15. Preferably, when calculating these ratios, the next full integer is selected in case that the division does not have a full integer as a result (e.g. 100 divided by 8 is 12.5 and the next full integer is 13). Preferably, the kernel and the pixelized representation have the identical aspect ratio.

Preferably, the kernel has an odd number of rows of pixels and an odd number of columns of pixels. However, in case that the number of rows of pixels and/or the number of columns of pixels of the kernel, respectively, is even, the kernel is considered to be centered at a pixel within the at least one region of the pixelized representation if it is centered at a pixel which is at least one of the pixels within which the center (especially the geometric center) of the kernel is located.

For example, the at least one region is centered at the pixelized representation of the cross section. Therefore, the pixelized representation preferably has an odd number of rows of pixels and an odd number of columns of pixels. However, in case that the number of rows of pixels and/or the number of columns of pixels of the pixelized representation, respectively, is even, the at least one region is considered to be centered if it is centered at a pixel which is at least one of the pixels within which the center of the pixelized representation is located.

For example, the width and/or the height of the at least one region of the pixelized representation is smaller than, respectively, the width and/or the height of the pixelized representation of the cross section. Preferably, the sum of the width of the at least one region of the pixelized representation of the cross section and the width of the kernel is smaller than or equal to the width of the pixelized representation of the cross section and/or the sum of the height of the at least one region of the pixelized representation of the cross section and the height of the kernel is smaller than or equal to the height of the pixelized representation of the cross section. This is beneficial because in this case the kernel always has a full overlap with the pixelized representation of the cross section if the at least one region is centered at the pixelized representation of the cross section.

It is also preferred that the sum of the width of the at least one first area and the width of the kernel is smaller than or equal to the width of a first part of the pixelized representation of the cross section which comprises all specific fins of the first group of fins and/or the sum of the height of the at least one first area and the height of the kernel is smaller than or equal to the height of the first part of the pixelized representation of the cross section.

It is also preferred that the sum of the width of the at least one second area and the width of the kernel is smaller than or equal to the width of a second part of the pixelized representation of the cross section which comprises all specific fins of the second group of fins and/or the sum of the height of the at least one second area and the height of the kernel is smaller than or equal to the height of the second part of the pixelized representation of the cross section.

Preferably the at least one region of the pixelized representation is the joint area of the first part of the pixelized representation and the second part of the pixelized representation.

Preferably the at least one region of the pixelized representation is the joint area of the first area and the second area.

However, it is also preferred that the at least one region of the pixelized representation is identical to the entire pixelized representation of the cross section. In this case symmetric boundary conditions may be chosen. Symmetric boundary conditions are preferred because this way the density parameter can be also calculated for edge pixels (pixels close to the edges of the cross section), for which the kernel exceeds the edges of the pixelized representation when centered at the respective edge pixels. Hence, for those pixels (only) a special treatment for the perimeters of the parts of the kernel that are outside of the pixelized representation is possible in a defined manner when calculating the density parameters. Choosing symmetric boundary conditions, entails a mirrored design with respect to every edge of the rectangular cross section, which is a preferred and elegant solution to address exceeding kernels.

For calculating the density parameter for an individual pixel in a preferred manner, the kernel is centered at that individual pixel. This results in the situation that the kernel has an overlap (preferably a full overlap) with the pixelized representation (the overlap may be also outside of the at least one region, as it is particularly the case for pixels close to the border of the at least one region) of the cross section (or optionally of the mirrored design). This overlap is the mentioned specific area. Within that specific area a set of pixels of the pixelized representation is located. With the known real extension of the cross section and with the known number of rows of pixels and the known number of columns of pixels, respectively, of the pixelized representation of the cross section, also the area of the portion of the cross section corresponding to the specific area of the pixelized representation covered by the kernel centered at the respective pixel of the pixelized representation is known (or can be calculated easily) (especially if the size of the kernel is known). Alternatively, the area can be determined in a convenient way based on the predefined average length associated with a single pixel, which has already been described above and will be described later in more detail. The density parameter can then be calculated in that the sum of the values of the pixels of the pixelized representation which pixels are located within the specific area is calculated, which sum then is multiplied with the predefined average length associated with a single pixel (see below for further information on how to calculate the predefined average length in an exemplary way), which product then is divided by the value of the area of the portion of the cross section corresponding to the specific area of the pixelized representation covered by the kernel centered at the respective pixel of the pixelized representation. Actually, the denominator of the ratio may also be defined as the number of pixels of the kernel multiplied with the square of the predefined average length associated with a single.

Consequently, in preferred embodiments, by subsequently centering the kernel at each pixel of all pixels within the at least one region of the pixelized representation, a density parameter can be obtained for each pixel within the at least one region of the pixelized representation. Basically, the values of the set of density parameters of the at least one region of the pixelized representation represent a low-pass filtered version of that region of the pixelized representation.

Preferably, the density parameter for each pixel within the at least one region of the pixelized representation has a value which is or can be obtained based at least in part on a convolution of the pixelized representation and the kernel.

A specific fin is preferably said to be within the first/second area of the at least one region of the pixelized representation if a (pixelized) cross section of that specific fin is present within the first/second area.

Preferably the first area and the second area are adjacent to each other. Preferably the first part of the pixelized representation and the second part of the pixelized representation are adjacent to each other.

Preferably in the first area are no specific fins of the second group of fins.

Preferably in the second area are no specific fins of the first group of fins.

When calculating the density parameters for the pixels of the first area, the kernel may have an overlap with pixels outside the first area, especially with pixels of the second area. However, preferably, when calculating the density parameters for the pixels of the first area, the kernel has no overlap with pixels outside the first area and/or with pixels of the second area.

Preferably, when calculating the density parameters for the pixels of the first area, the kernel has no overlap with pixels outside the first part of the pixelized representation of the cross section.

Likewise, when calculating the density parameters for the pixels of the second area, the kernel may have an overlap with pixels outside the second area, especially with pixels of the first area.

However, preferably, when calculating the density parameters for the pixels of the second area, the kernel has no overlap with pixels outside the second area and/or with pixels of the first area.

Preferably, when calculating the density parameters for the pixels of the second area, the kernel has no overlap with pixels outside the second part of the pixelized representation of the cross section.

Cooling elements for which the density parameters of all pixels in each case within the first area and/or the second area have one or more statistical variables (especially the mean value, the median value, the mode value and/or the standard deviation) respectively taking values within the limits stated above surprisingly turn out to have a particularly high cooling efficiency. Of course, for the respective statistical variables the density parameters of all pixels in each case within the first area and/or the second area are considered.

The density parameters of all pixels in each case within the first area and/or the second area of a preferred cooling element, therefore, fulfill one or more of the respective statistical variables. Hence, a preferred cooling element fulfills one or more of the statistical variables. Again, if two areas are considered, then pixels of each area fulfill the respective limitation.

Thus, a process of designing a preferred cooling element may incorporate adjusting the perimeters of the specific fins such that the density parameters of all pixels in each case within the first area and/or the second area fulfill one or more of the respective statistical variables.

Hence, the following exemplary procedure may be performed for calculating the density parameter for pixels of a pixelized representation of the cross section (especially for pixels of the first and/or second area) in a preferred manner: **First,** a pixelized representation of the cross section is obtained. Here, every pixel which corresponds to a perimeter has the value one (1) while the other pixels all have value zero (0). The number of columns and the number of rows, hence the number of pixels, respectively, of the pixelized representation may be determined for example as described above. **Second,** a kernel is defined. The kernel is a rectangular pattern of pixels (which may have all the value one (1)) which covers N_{CK} columns and N_{RK} rows of pixels of the pixelized representation. The size of the kernel may be determined for example as described above. **Third,** a region is selected within the pixelized representation for the pixels of which the density parameter is to be calculated, furthermore a first area (with one or more specific fins of the first group of fins) and a second area (with one or more specific fins of the second group of fins) is selected, while the first area and the second area are comprised by the selected region. The region may also be chosen as large as the pixelized representation is. However, preferably, the region is chosen such that for every pixel within the region, the kernel, when centered at that pixel, has full overlap with the pixelized representation. Even more preferred is, that (i) the first area is chosen such that for every pixel within the first area, the kernel, when centered at that pixel, has full overlap with a first part of the pixelized representation which (as described already above) comprises all specific fins of the first group of fins and/or (ii) the second area is chosen such that for every pixel within the second area, the kernel, when centered at that pixel, has full overlap with a second part of the pixelized representation which (as described already above) comprises all specific fins of the second group of fins. **Fourth,** for each pixel within the region (alternatively for each pixel at least within the first area and the second area), the following procedure is performed: The kernel is centered at the respective pixel and the values of all pixels within an area covered by the kernel, i.e. the specific area, are summed; Then the sum is multiplied with the predefined average length associated with a single pixel; Then the product is divided by the number of pixels of the kernel multiplied with the square of the predefined average length associated with a single pixel (hence, the denominator of the ratio is the area of the portion of the cross section corresponding to the specific area of the pixelized representation covered by the kernel centered at the respective pixel of the pixelized representation); The result is the value the density parameter takes for that pixel. Of course, for each pixel within the region the "specific area" is a different portion of the pixelized representation.

Alternatively or in addition an embodiment can be provided in which
- the mean values of the density parameters of all pixels, respectively, within the first area and the second area differ by at least 1 % and/or at most 100 %,
- the median values of the density parameters of all pixels, respectively, within the first area and the second area differ by at least 1 % and/or at most 100 %,
- the mode values of the density parameters of all pixels, respectively, within the first area and the second area differ by at least 1 % and/or at most 100 %,
   and/or
- the standard deviations of the density parameters of all pixels, respectively, within the first area and the second area differ by at least 1 % and/or at most 100 %.

In other words, the variables of the pixels of the first and second areas are compared with each other.

Alternatively or in addition an embodiment can be provided according to which in each case of the first area and/or the second area a histogram of the density parameters of respective all pixels of the first area and/or the second area of the pixelized representation can be determined and each of which histograms follows a beta distribution, especially having a skewness between -1 and 0.3, especially between -1 and -0.2 or between 0 and 3 or between 0.01 and 0.3, preferably the two histograms have a different skewness by at least 1 % and/or at most 100 %, and/or a histogram of the density parameters of all pixels of the second area of the pixelized representation can be determined and which histogram follows a beta distribution, especially having a skewness between -1 and 0.3, especially between -1 and -0.2 or between 0 and 3 or between 0.01 and 0.3.

A cooling element for which the respective density parameters of the pixels in each case of the first area and/or the second area result in a histogram of respective type of distribution and/or having a respective skewness turn out to have a particularly high cooling efficiency. For the histogram, of course, the density parameters of all pixels within the respective first and/or second area are considered.

Thus, a process of designing a preferred cooling element may incorporate adjusting the perimeters of the specific fins (especially the specific fins which are in each case within the first and/or second area) such that the histogram of the density parameters of all pixels in each case within the first area and/or the second area is of the respective type of distribution and/or has the respective skewness.

Preferably, each histogram and/or distribution has a mean value, a median value, a mode value and/or a standard deviation as stated above for the density parameters.

If pixels of both areas are considered, the fins preferably can be designed such that the two respective histograms fulfill the stated limitation.

Alternatively or in addition an embodiment can be provided in which the predefined average length associated with a single pixel is an average length determined based at least in part on (i) an extension along the first dimension and an extension along the second dimension, respectively, of the cross section, and the number of pixels along the first dimension and the number of pixels along the second dimension, respectively, of the pixelized representation of the cross section and/or (ii) a minimum feature size and a specific number of pixels.

The number of pixels along the first dimension may be the number of columns of the pixelized representation, N_{CP}, and/or the number of pixels along the second dimension may be the number of rows of the pixelized representation, N_{RP}. Furthermore, the pixelized representation may correspond to a region of the cross section which region has width W (unit µm) and height H (unit µm).

Preferably, the predefined average length associated with a single pixel is calculated by 0.5*(W/N_{CP} + H/N_{RP}).

Alternatively, if the predefined average length associated with a single pixel is determined based at least in part on the minimum feature size and the specific number of pixels, the minimum feature size may be between 1 µm and 100 µm and the specific number of pixels may be 100 pixels, 300 pixels, 500 pixels or 1000 pixels and the predefined average length may be the ratio of the minimum feature size to the specific number of pixels. Reference can also be made to the description above, where further details and examples on calculating the predefined average length associated with a single pixel based on the minimum feature size and the specific number of pixels have been provided.

It is noted that the minimum feature size may be predefined by a user. For example, the minimum feature may be between 1 µm and 100 mm, such as 1 µm, 10 µm, 30 µm, 50 µm, 70 µm or 100 µm.

It is noted that the specific number of pixels may be predefined by a user. For example, the specific number of pixels may be between 100 pixels and 1000 pixels, such as 100 pixels, 300 pixels, 500 pixels or 1000 pixels.

Alternatively or in addition an embodiment can be provided in which the kernel has the same aspect ratio as the at least one region of the pixelized representation and/or as the pixelized representation.

It turns out that this result in a particular beneficial density parameter.

Alternatively or in addition an embodiment can be provided in which the size of the kernel and the size of the at least one region of the pixelized representation are matched such that for each pixel within the at least one region of the pixelized representation the kernel, when centered at the respective pixel of the pixelized representation, has a complete overlap with the pixelized representation.

This way a full overlap of the kernel with the pixelized representation can be obtained for each pixel within the at least one region of the pixelized representation.

Preferably, also the relative location of the at least one region of the pixelized representation within the pixelized representation is in addition part of the matching. Hence, the size of the kernel, the size of the at least one region of the pixelized representation and the relative location of the at least one region of the pixelized representation within the pixelized representation are matched such that for each pixel within the at least one region of the pixelized representation the kernel, when centered at the respective pixel of the pixelized representation, has a complete overlap with the pixelized representation.

However, it is also preferred that the first area and the second area are of identical size and/or aspect ratio and/or that the size of the kernel and the size of the first area are matched such that for each pixel within the first area the kernel, when centered at the respective pixel of the first area, has a complete overlap with the region and/or that the size of the kernel and the size of the second area are matched such that for each pixel within the second area the kernel, when centered at the respective pixel of the second area, has a complete overlap with the region.

Alternatively or in addition an embodiment can be provided in which a channel-width parameter *ωᵣ* can be defined which for each pixel within the at least one region of the pixelized representation takes the value of the inverse of the density parameter *ρₘ* of the respective pixel,
wherein preferably in each case of the first area and/or the second area
- each channel-width parameter *ωᵣ* has a value between 30 µm and 900 µm, especially between 88 µm and 836 µm,
- the mean value of the channel-width parameters of all respective pixels within the first area and/or second area of the pixelized representation is between 150 µm and 300 µm, especially between 155 µm and 260 µm,
- the median value of the channel-width parameters of all respective pixels within the first area and/or second area of the pixelized representation is between 130 µm and 250 µm, especially between 147 µm and 240 µm,
- the mode value of the channel-width parameters of all respective pixels within the first area and/or second area of the pixelized representation is between 120 µm and 250 µm, especially between 142 µm and 225 µm, and/or
- the standard deviation of the channel-width parameters of all respective pixels within the first area and/or second area of the pixelized representation is between 30 µm and 90 µm, especially between 35 µm and 87 µm.

It turns out that the channel-width parameter is a variable which can be used to describe the design of the cooling element in a preferred manner.

The channel-width parameter has units of length and could be interpreted as a characteristic length scale within each kernel. Specifically, it may represent the average distance between the fins or the average free space within a kernel if the fins are uniformly distributed. This length scale could be understood as a measure of fin sparsity or the scale of open space within areas of the size of the kernel. It turns out that the channel-width parameter provides insights into the flow characteristics within areas of the size of the kernel, as larger values would indicate more open space which might correlate with lower resistance to fluid flow, and vice versa. That length can be considered as the average channel width within areas of the size of the kernel.

Obtaining a channel-width parameter for an individual pixel of the at least one region of the pixelized representation (for example during the design process of a cooling element and/or during verification/review of an existing cooling element) is easily possible. For example, once the density parameters of the pixels of the at least one region of the pixelized representation have been determined, also the channel-width parameter can be determined in a straight-forward manner for each of these pixels by calculating the inverse of the density parameter of the respective pixel. The inverse (e.g. value X) is then the value the channel-width parameter of that pixel takes for that pixel.

Cooling elements for which the channel-width parameters of all pixels in each case within the first area and/or the second area have one or more statistical variables (especially the mean value, the median value, the mode value and/or the standard deviation) respectively taking values within the limits stated above surprisingly turn out to have a particularly high cooling efficiency. Of course, for the respective statistical variables the channel-width parameters of all pixels in each case within the first area and/or the second area are considered.

The channel-width parameters of all pixels in each case within the first area and/or the second area of a preferred cooling element, therefore, fulfill one or more of the respective statistical variables. Hence, a preferred cooling element fulfills one or more of the statistical variables. Again, if two areas are considered, then pixels of each area fulfill the respective limitation.

Thus, a process of designing a preferred cooling element may incorporate adjusting the perimeters of the specific fins such that ultimately the channel-width parameters of all pixels in each case within the first area and/or the second area fulfill one or more of the respective statistical variables.

Alternatively or in addition an embodiment can be provided in which
- the mean values of the channel-width parameters of all pixels, respectively, within the first area and the second area differ by at least 1 % and/or at most 100 %,
- the median values of the channel-width parameters of all pixels, respectively, within the first area and the second area differ by at least 1 % and/or at most 100 %,
- the mode values of the channel-width parameters of all pixels, respectively, within the first area and the second area differ by at least 1 % and/or at most 100 %,
   and/or
- the standard deviations of the channel-width parameters of all pixels, respectively, within the first area and the second area differ by at least 1 % and/or at most 100 %.

In other words, the variables of the pixels of the first and second areas are compared with each other.

Alternatively or in addition an embodiment can be provided according to which in each case of the first area and/or the second area a histogram of the channel-width parameters of respective all pixels within the first area and/or the second area of the pixelized representation can be determined and each of which histograms follows a beta distribution, especially having a skewness between 0 and 3, especially between 1 and 3, preferably the two histograms have a different skewness by at least 1 % and/or at most 100 %, and/or a histogram of the channel-width parameters of all pixels within the second area of the pixelized representation can be determined and which histogram follows a beta distribution, especially having a skewness between 0 and 3, especially between 1 and 3.

A cooling element having pixels in the first and/or second area of the pixelized representation, the channel-width parameters of which result in a histogram of respective type of distribution and/or having a respective skewness turn out to have a particularly high cooling efficiency. For the histogram, of course, the channel-width parameters of all pixels within the respective first and/or second area are considered.

Thus, a process of designing a preferred cooling element may incorporate adjusting the perimeters of the specific fins (especially of the specific fins which are in each case within the first and/or second area) such that the histogram of the channel-width parameters of all pixels in each case within the first area and/or the second area is of the respective type of distribution and/or has the respective skewness.

Preferably, each histogram and/or distribution has a mean value, a median value, a mode value and/or a standard deviation as stated above for the channel-width parameters.

If pixels of both areas are considered, the fins preferably can be designed such that the two respective histograms fulfill the stated limitation.

Alternatively or in addition an embodiment can be provided in which the histograms of the parameters equivalent-diameter parameter, roundness parameter, mean-diameter parameter, density parameter and channel-width parameter can be determined, respectively, for the specific fins of the first group of fins and for the fins of the second group of fins,
wherein for the specific fins in each case of the first group of fins and/or second group of fins at least two, preferably three or more, of the histograms follow a skewed distribution, at least one, preferably two or more, of which follows a left skewed distribution and at least one of which follows a right skewed distribution,
especially for the specific fins in each case of the first group of fins and/or second group of fins the histogram of the equivalent-diameter parameter, mean-diameter parameter, density parameter and/or channel-width parameter follows a left skewed distribution and/or the histogram of the roundness parameters follow a right skewed distribution.

It turns out that preferred cooling elements having a high cooling efficiency have a corresponding characteristic of the individual distributions.

Thus, a process of designing a preferred cooling element may incorporate adjusting the perimeters of the specific fins such that the histograms of the at least two parameters have a respective skewed distribution.

Alternatively or in addition an embodiment can be provided in which the height of the cooling element is between 1 µm and 2 cm.

Alternatively or in addition an embodiment can be provided in which the material of the specific fins is a material with good thermal conductivity and/or comprising at least one of nickel, brass, diamond, copper, aluminium, stainless steel, silicon, aluminium nitride, invar, kovar, Hastelloy, Inconel, or polymers.

A material with good thermal conductivity can be a material having a thermal conductivity of between 100 W / (m K) and 2000 W / (m K), especially between 120 W / (m K) and 450 W / (m K). For example, the material may be silicon and/or may have a thermal conductivity of 149 W / (m K). For example, the material may be copper and/or may have a thermal conductivity of 398 W / (m K).

Alternatively or in addition an embodiment can be provided in which the number of specific fins (especially in each case of the first group of fins and second group of fins) is between 2 and 300,000,000

Alternatively or in addition an embodiment can be provided in which cross section of the superior volume lying within the cross-sectional plane is rectangular and/or has an area of between 1 µm² and 500 cm².

For example, the width of the cross section may be between 1 mm and 100 mm, especially between 5 mm and 40 mm, and/or the height of the cross section may be between 1 mm and 100 mm, especially between 5 mm and 40 mm.

Alternatively or in addition an embodiment can be provided in which the at least one region of the pixelized representation is a rectangular region and/or corresponds to a portion of the cross section of the superior volume lying within the cross-sectional plane which has an area of at least 10 %, 20 %, 30 %, 50 % or 70 % of the total area of the cross-section of the cooling element.

Alternatively or in addition an embodiment can be provided in which the cooling element is designed as a cooling structure, especially as a microfluidic cooling structure.

The cooling structure can be a separate structure from the element to be cooled or a structure built at least in part in one piece with the element to be cooled. The cooling structure can also be a structure which is integrated at least in part in the element to be cooled.

Alternatively or in addition an embodiment can be provided in which at least some of the specific fins are obtained at least in part by extruding structures along a third dimension, especially by using an additive manufacturing technique, such as a 3D printing technique, and/or a deposition technique, such as electrodeposition and/or screen printing.

This allows for a precise and cost-efficient design of at least parts of the cooling element. Especially, this way the fins can be designed with customized shapes.

However, in other embodiments a subtractive technique can be used, such as etching and/or machining or electro discharge machining.

Alternatively or in addition an embodiment can be provided in which the superior volume is enclosed at least in part by a solid frame.

The solid frame allows to provide a spatial confinement of the superior volume, hence, of the network of interconnected channels. It is especially possible to restrict the flow of the liquid cooling agent in an easy and efficient way to the superior volume in that the solid frame prevents the liquid cooling agent from leaving the superior volume. Of course, there may be provided at least one inlet and/or at least one outlet in the solid frame. These allow the liquid cooling agent to flow into or out of the superior volume at definite locations.

Alternatively or in addition, the network of interconnected channels and/or the superior volume may be in fluidal communication with at least one inlet and/or at least one outlet. The inlet and outlet allow that the liquid cooling agent can flow into the network of interconnected channels and flow out of the network of interconnected channels.

Alternatively or in addition an embodiment can be provided in which the cooling element is or can be attached with another element from which heat is to be dissipated.

This way also existing element can be retrofitted with the preferred cooling element. Hence, heat can be dissipated also from existing elements in a convenient and cost-efficient manner.

Alternatively or in addition an embodiment can be provided in which for the cross section of the superior volume within the cross-sectional plane the ratio of the sum of the surface areas of the specific fins to the area of the cross section is smaller than 0.5 or between 0.1 and 0.5.

Cooling elements having a respective "fins-to-chip-ratio" turn out to have a particular high cooling efficiency.

Alternatively or in addition an embodiment can be provided in which for the cross section of the superior volume within the cross-sectional plane the ratio of the difference between the area of the cross section and the sum of the surface areas of the specific fins to the area of the cross section is larger than 0.5 or between 0.5 and 0.9.

Cooling elements having a respective "channel-to-chip-ratio" turn out to have a particular high cooling efficiency.

Alternatively or in addition an embodiment can be provided in which for the cross section of the superior volume within the cross-sectional plane the ratio of the sum of the surface areas of the specific fins to the difference between the area of the cross section and the sum of the surface areas of the specific fins is between 0.15 and 0.9.

Cooling elements having a respective "fins-to-channel-ratio" turn out to have a particular high cooling efficiency.

Alternatively or in addition an embodiment can be provided in which the cross section of the superior volume lying within the cross-sectional plane of the cooling element is smaller than the cross section of the cooling element lying within that cross-sectional plane.

In other words, the cooling structure in terms of the superior volume comprising the fins can only be present in a part of the cooling element, for example a cooling area of less than 100% of the total area.

Alternatively or in addition an embodiment can be provided in which the cooling element is implemented as at least part of a coldplate, especially in form of a single coldplate, and/or at least part of a chip or at least in part in-chip.

If the cooling element is implemented as at least part of a coldplate, the cooling element may be part of a manifold with an integrated coldplate or a single manifold. The manifold or integrated coldplate may have a surface which may be in contact and/or heat exchange with the element to be cooled. Further, the cooling element may be located on the surface or an integral part of the surface.

If the cooling element is implemented as at least part of a chip or at least in part in-chip, the cooling element may be integrated in a semiconductor device. The cooling element may be located on a surface of the chip. The cooling element may be an integral part of the element to be cooled. In other words, the fins and cooling structures can be provided in or on the chip itself.

Thus, preferably, the cooling element is designed at least in part as a coldplate (comprising a single or multiple, such as two, coldplates).

For example, if the cooling element is implemented as at least part of a chip or at least in part in-chip, the cooling element or parts thereof, such as the fins of the first group of fins and/or the fins of the second group of fins, may be provided on a surface of the chip, e.g. etched on the surface.

Alternatively or in addition an embodiment can be provided in which the cooling element at least in part is designed and/or implemented as coldplate, especially a copper coldplate, preferably the base element is designed and/or implemented as coldplate.

Alternatively or in addition an embodiment can be provided in which the fins of the first group of fins and the fins of the second group of fins are provided on the same base element, especially on the same coldplate, or on different base elements, especially on different coldplates, wherein preferably the fins of the first group of fins are provided on at least one first base element, especially at least one first coldplate, and/or the fins of the second group of fins are provided on at least one second base element, especially at least one second coldplate.

Providing different coldplates allow for a modular design of the cooling element.

For example, the fins of the first group of fins may be provided on the first base element, especially the first coldplate, and/or the fins of the second group of fins may be provided on the second base element, especially the second coldplate.

Multiple base elements are particularly preferred for an in-chip design. Therefore, the cooling element preferably is designed as an in-chip design.

Alternatively or in addition an embodiment can be provided in which the fins of the first group of fins and the fins of the second group of fins are provided on the same chip or on different chips, especially computing chips and memory chips

For example, the fins of the first group of fins may be provided on a first chip of a first type and/or the fins of the second group of fins may be provided on a second chip of a second type. The first chip of first type may be for example a high heat flux chip, such as a computing chip. The second chip of second type may be for example a low heat flux chip, such as a memory chip.

The problem can be solved by the invention according to a second aspect in that a stack comprising at least one semiconductor device and at least one cooling element according to the first aspect of the invention, is proposed.

All advantages and features described above with respect to the cooling element according to the first aspect of the invention also apply for the stack. Especially, the cooling element may be adapted to dissipate heat from the semiconductor device considering the local variation of a heat generation rate of the semiconductor device.

For example, the semiconductor device may comprise multiple chips. The chips may act as heat sources in operation.

Alternatively or in addition an embodiment can be provided in which the cooling element is integrally designed with the semiconductor device.

This way a particular high cooling efficiency can be obtained.

Alternatively or in addition an embodiment can be provided in which the cooling element is, preferably fixedly or releasably, attached to the semiconductor device.

For example, the cooling element may be fixedly attached to the semiconductor device by clueing, soldering and/or bonding.

For example, the cooling element may be releasably attached to the semiconductor device by means of a connector and/or a latching mechanism.

### Brief description of the figures

Various aspects of this invention will become apparent to those skilled in the art from the following detailed description of preferred embodiments, when read in light of the accompanying schematic drawings, wherein
- Fig. 1: shows a cooling element according to the first aspect of the invention in an exploded view;
- Fig. 2: shows a base element of the cooling element of Fig. 1 in a top view;
- Fig. 3: shows a cross section of a superior volume of the cooling element of Fig. 1;
- Fig. 4: shows a pixelized representation of the cross section of Fig. 3 with the perimeters of the specific fins indicated as black solid lines;
- Fig. 5: shows a histogram and PDF of the equivalent-diameter parameters of all specific fins of a first group of fins of the cross section of Fig. 3;
- Fig. 6: shows a histogram and PDF of the roundness parameters of all specific fins of the first group of fins of the cross section of Fig. 3;
- Fig. 7: shows a histogram and PDF of the mean-diameter parameters of all specific fins of the first group of fins of the cross section of Fig. 3;
- Fig. 8: shows a histogram and PDF of the density parameters of all pixels within a first area of a region of the pixelized representation of the cross section indicated in Fig. 4;
- Fig. 9: shows a histogram and PDF of the channel-width parameters of all pixels of the first area within the region of the pixelized representation of the cross section indicated in Fig. 4;
- Fig. 10: shows a first alternative base element for the cooling element of Fig. 1 in a top view;
- Fig. 11: shows a second alternative base element for the cooling element of Fig. 1 in a top view; and
- Fig. 12: shows a third alternative base element for the cooling element of Fig. 1 in a top view.

### Detailed description of the figures

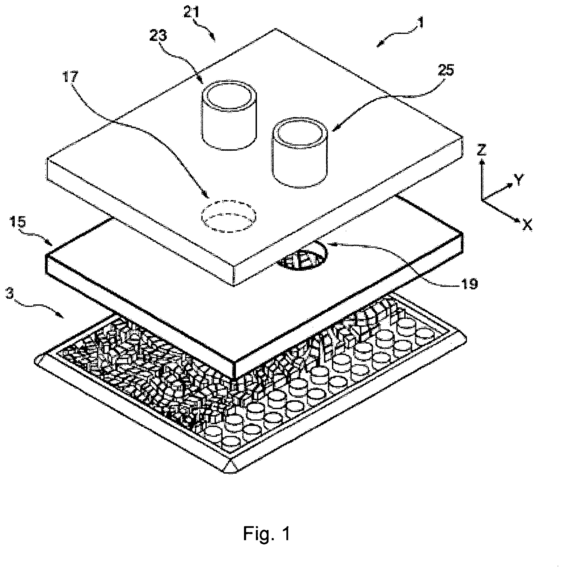

**Fig. 1** shows a cooling element 1 according to the first aspect of the invention in an exploded view in a schematic manner.

The cooling element 1 comprises a base element 3 which is particularly designed in form of a coldplate. The bottom surface of the base element 3 can be attached to an element to be cooled (not shown in Fig. 1), such as a semiconductor device. For example, the base element 3 may be in contact with the element to be cooled through a thermal interface material. The base element 3 may be made of copper and be obtained by a 3D printing technique, while other materials and/or manufacturing methods may also be possible. Thus, the cooling element 1 is configured for heat-transferring contact with another element from which heat is to dissipated during use.

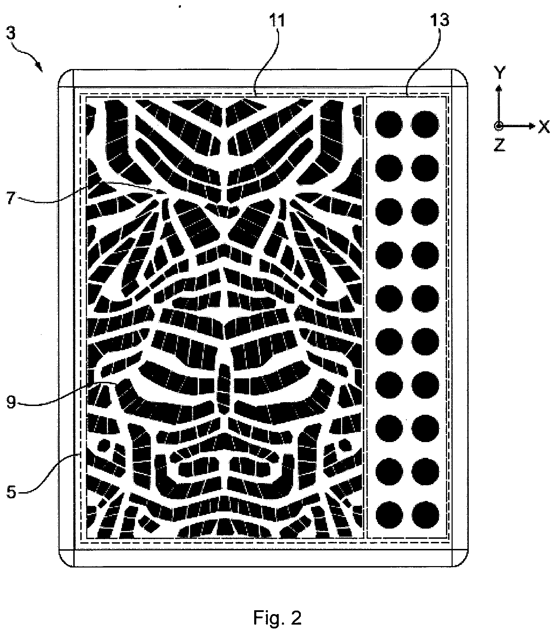

**Fig. 2** shows the base element 3 of the cooling element 1 in a top view.

In the base element 3 a superior volume 5 can be defined in which a cooling liquid cooling agent can flow. The top surface of superior volume 5 is highlighted by a dashed rectangle. The superior volume 5 extends also along the Z direction. Within the superior volume 5 a network of interconnected channels 7 for guiding the cooling agent is provided. In Fig. 2 the white areas shown in superior volume 5 is the network of interconnected channels 7. Within the superior volume 5 a plurality of fins 9 are provided, which fins contribute to the formation of boundaries of the channels of the network of interconnected channels 7 (see Fig. 1 and Fig. 2). The black islands correspond to the fins 9 and only one of which is labeled with a reference sign in Fig. 2. Here, the height of the superior volume 5 is identical to the height of the fins 9 and all fins 9 are provided and extend within the superior volume 5.

To be more precise, there are fins of a first group of fins which are arranged within a definable first volume 11 (which is highlighted by a long-dashed rectangle). Furthermore, there are fins of a second group of fins which are respectively arranged within a definable second volume 13 (which is highlighted by another long-dashed rectangle). The superior volume 5 is the joint volume of the first volume 11 and the second volume 13.

At least the fins of the first group of fins contribute at least in part to the formation of boundaries of the channels of at least one first part of the network of interconnected channels (namely the first part is provided within the first volume 11) and at least the fins of the second group of fins contribute at least in part to the formation of boundaries of the channels of at least one second part of the network of interconnected channels (namely the second part is provided within the second volume 13).

The fins of the first group of fins are arranged in an irregular pattern. This irregular pattern may be at least in part a result of an optimization process. The fins of the second group of fins are arranged in a regular pattern (for example, as shown in Fig. 2 the fins of the second group of fins are arranged in two columns and ten rows). Thus, the fins of the first group of fins are arranged in a different pattern than the fins of the second group of fins.

During use of the cooling element 1 a heat dissipation rate of the first part of the network of interconnected channels is different, especially higher, than a heat dissipation rate of the second part of the network of interconnected channels.

The first part of the network of interconnected channels and the second part of the network of interconnected channels are, hence, designed in such a way so as to dissipate different amounts of heat from different regions of the element to be cooled during use of the cooling element 1. This way different structures of the element to be cooled having different heat generations rates can be taken into account.

In other embodiments there may be defined two or more second volumes 13 and each second volume may comprise fins of the second group of fins which respectively are arranged in a regular pattern, and between which first and second volumes 11 and 13 the liquid cooling agent can flow.

In other embodiments the fins of the second group of fins are also arranged in an irregular pattern. In this case the fins of the first group of fins may be arranged in a first irregular pattern and the fins of the second group of fins may be arranged in a second irregular pattern. An example for this scenario will also be described later.

The cooling element 1 comprises also a cover element 15 which has two recesses 17 and 19. The cover element 15 can be used to cover the base element 3 during use of the cooling element 1. For example, the cover element 15 and the base element 3 are directly bonded, especially via thermocompression, and/or brazed to each other. The recesses 17 and 19 forms part of an inlet and an outlet and allow a fluidical connection between the network of interconnected channels 7 and an environment of the cooling element 1. For example, recess 17 may be used as inlet and recess 19 may be used as outlet.

The recesses 17 and 19 (inlet and outlet) may, thus, be designed as an inlet and an outlet of the network of interconnected channels 7 for supplying the liquid cooling agent to the network of interconnected channels 7 and for discharging the liquid cooling agent from the network of interconnected channels 7. This way, in the superior volume 5, at least in a state in which the cooling element 1 is in heat-transferring contact with the another element from which heat is to be dissipated during use, at least in regions the liquid cooling agent can flow, from the inlet (e.g. recess 17) towards the outlet (e.g. recess 19), so that heat can be dissipated.

The cooling element 1 comprises also a top element 21 which is or can be brought in contact with the cover element 15. The top element 21 may comprise multiple integrally designed manifolds, which manifolds may cooperate with the recesses 17 and 19 of the cover element 15. The top element 21 comprises means 23 and 25 for connecting the manifolds to external piping and/or to external connection means for supplying the liquid cooling agent to the inlet (e.g. recess 17) and discharging the liquid cooling agent away from the outlet (e.g. recess 19). Hence, the liquid cooling agent can be guided into the network of interconnected channels 7 and out. The top element 21 may be directly bonded to the cover element 15. The top element 21 may be made of copper. The top element 21 may also be sealed to the cover element 15 through O-rings (not shown in Fig. 1).

The fins of the first and second groups of fins are integrally built with the base element 3. While in Figs. 1 and 2 the base element is designed as one single piece, in other embodiment, the fins of the first group of fins may be provided on a first base element and the fins of the second group of fins may be provided on a second base element.

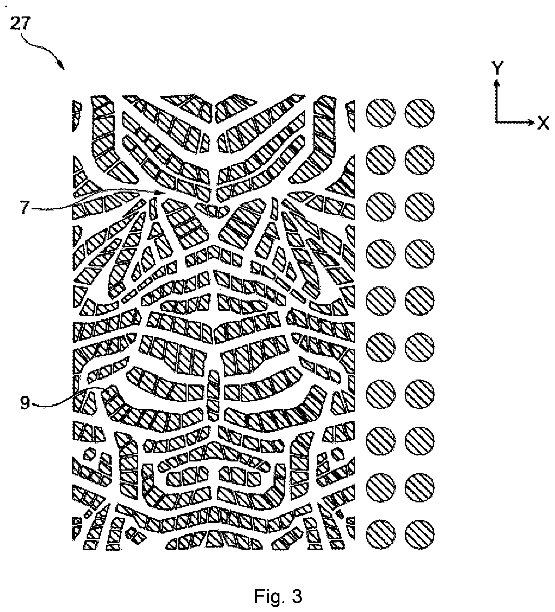

**Fig. 3** shows a cross section 27 of the superior volume 5 lying within a cross-sectional plane of the cooling element 1. The cross-sectional plane is parallel to the XY plane of the coordinate system shown in the Figures. The cross-sectional plane is preferably a horizontal plane. In the present case the cross-sectional plane is parallel to the above-mentioned bottom surface of the cooling element 1 (especially the base element 3 thereof).

The white areas denote the network of interconnected channels 7 where the liquid cooling agent can flow, while the hashed areas 9 (again, only one of them is labeled also in Fig. 3) correspond to the solid fins 9 of the first and second groups of fins of the cooling element 1. In the cross section 27 to each of the N fins 9 is referred to as a specific fin 9. And each specific fin 9 in the cross section 21 has a perimeter.

The cross section 17 has an extension along the X direction (i.e. its width) of W=1.59 cm and an extension along the Y direction (i.e. its height) of H=2.13 mm.

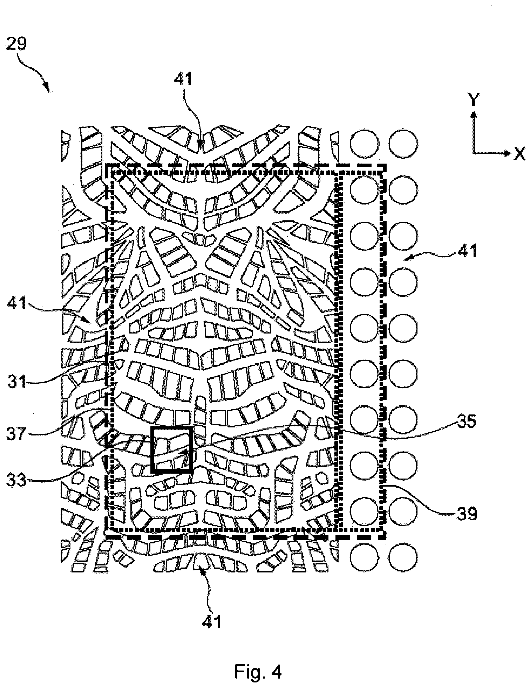

**Fig. 4** shows a pixelized representation 29 of the cross section 27 shown in Fig. 3 with the perimeters of the specific fins 9 indicated as black solid lines. The pixelized representation 29 has N_{CP}=1597 columns (i.e. 1597 pixels along the X direction) and N_{RP}=2149 rows (i.e. 2149 pixels along the Y direction), hence, 3,431,953 pixels in total. Therefore, the individual pixels may not be seen in Fig. 4. Every pixel of the pixelized representation 29 which belongs to a perimeter has the value one (1) and the other pixels of the pixelized representation 29 have value zero (0). The width of the perimeters is chosen to be 1 pixel. For example, the representation of Fig. 4 may be obtained from the one of Fig. 3 in that an edge detection algorithm is applied on a pixelized representation of the cross section 27 shown in Fig. 3.

For each specific fin 9 in the cross section 27 (see Fig. 3), a perimeter parameter *Pₑ* can be defined which takes the value of the length of its associated perimeter in the cross section. Furthermore, for each specific fin 9 in the cross section 27 (see Fig. 3) a surface parameter *Sₑ* can be defined which takes the value of the area of its associated surface, which is an area enclosed by the perimeter associated with the respective specific fin 9. In Fig. 3 the surface of the individual specific fins 9 may be the respective hashed area.

With these parameters, for each specific fin 9 an equivalent-diameter parameter ${D}_{e} = 2 \sqrt{{S}_{e} / π}$, a roundness parameter $σ = 4 π \frac{{S}_{e}}{{P}_{e}^{2}}$ and a mean-diameter parameter ${d}_{32} = 4 \frac{{S}_{e}}{{P}_{e}}$ can be defined. Here, *Sₑ* being the surface parameter of the respective specific fin and *Pₑ* being the perimeter parameter of the respective specific fin.

There also can be defined for each pixel within a region 31 of the pixelized representation 29 a density parameter *ρₘ*. For calculating the density parameter for a particular pixel, a kernel 33, which here, for example, has a size of W_{K}=122 pixels along the X direction and H_{K}=165 pixels along the Y direction with all pixels having value 1, is centered at that particular pixel of the pixelized representation 29 and the values of the pixels of the pixelized representation 29 covered by the kernel 33, i.e. the pixels which are within a specific area 35 corresponding to the area of the kernel 33, are summed. The sum may be regarded as a convolution of the kernel 33 with the part of the pixelized representation 29 covered by the kernel 33. The sum is then multiplied with a predefined average length associated with a single pixel. This result is then divided by the value of the area which in the cross section 27 (i.e. the non-pixelized representation) corresponds to the specific area 35 of the pixelized representation 29.

The dimensions of the kernel 33 may be determined to be approximately 10 % of the dimensions of the region 21, but other choices may be possible as well. The width and the length of the kernel 33 is for example approximately 7,7 %, respectively, of the width and the length of the pixelized representation 29.

The predefined average length associated with a single pixel here is an average length determined based on the extension along the X direction of W=1.59 cm and the extension along the Y direction of H=2.13 cm, respectively, of the cross section 27, and the number of pixels along the X direction of N_{CP}=1597 and the number of pixels along the Y direction of N_{RP}=2149, respectively, of the pixelized representation 29 of the cross section 29. Hence, a length per pixel in X direction can be calculated as 1.59 cm / 1597 pixel = 9.95 µm / pixel and a length per pixel in Y direction can be calculated as 2.13 cm / 2149 pixel = 9.92 µm / pixel. The predefined average length associated with a single pixel can be calculated as the mean value of 9.95 µm / pixel and 9.92 µm/pixel, which is 9.94 µm/pixel.

If for each pixel within the region 31 of the pixelized representation 29 the density parameter is calculated, i.e. the kernel 33 is centered at every pixel and the density parameter is calculated as described above, a density map of the region 31 can be displayed, the pixel of which takes the values of the density parameters of the individual pixels. The density map basically is a lowpass filtered version of region 31.

There is a first area 37 (highlighted by a dotted rectangle) of the region 31 where several specific fins of the first group of fins are located and no specific fins of the second group of fins. And there is a second area 39 (highlighted by another dotted rectangle) of the region 31 where several specific fins of the second group of fins are located and no specific fins of the first group of fins. The region 31 is the joint area of the first area 37 and the second area 39.

It is noted that in Fig. 4 the region 21 is smaller than the total area of the pixelized representation 29 of the cross section 27 and that there are, therefore, margins 41 to the left, the right, the top and the bottom (see Fig. 4). Having respective margins 41 ensure that the kernel 33 has always full overlap with the pixelized representation 29 of the cross section 27, at whatever pixel within the region 31 the kernel 33 is centered.

It is noted that the size of region 31 may vary. For example, the region 31 may also be set to include the total area of the pixelized representation 29. In this case symmetric boundary conditions may be applied for calculating the density parameters for pixels close to the borders of the pixelized representation 29 for which pixels the kernel 33 has no full overlap with the pixelized representation 29. In this case all specific fins of the first group of fins are within the (respectively enlarged) first area 37 of the (enlarged) region 31 and all specific fins of the second group of fins are within the (respectively enlarged) second area 39 of the (enlarged) region 31. However, the region 31 may also be set to include only one or more or all specific fins of the first group of fins but no specific fins of the second group of fins, so that the region 31 may be identical to the respective chosen first area 37.

There also can be defined for each pixel within the region 31 of the pixelized representation 29 a channel-width parameter *ωᵣ*. The channel-width parameter takes for a particular pixel the inverse value of the density parameter for the respective pixel.

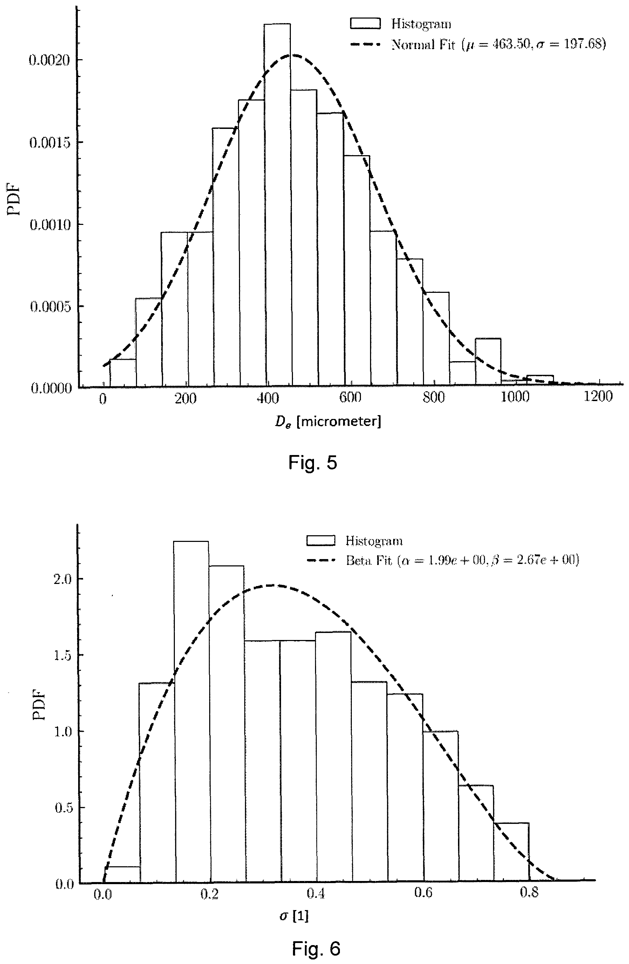

**Fig. 5** shows a histogram of the equivalent-diameter parameters of all specific fins of the first group of fins (which specific fins are located in the first volume 11) of the cross section 27 of Fig. 3. The histogram follows a normal distribution having a mean value of 463.5 µm and a standard deviation of 197.68 µm. The fit of the distribution (PDF) is also shown in Fig. 5.

**Fig. 6** shows a histogram of the roundness parameters of all specific fins of the first group of fins (which specific fins are located in the first volume 11) of the cross section 27 of Fig. 3. The histogram follows a beta distribution with parameter alpha is 1.99 and parameter beta is 2.67. The mean value is 0.36. The fit of the distribution (PDF) is also shown in Fig. 6.

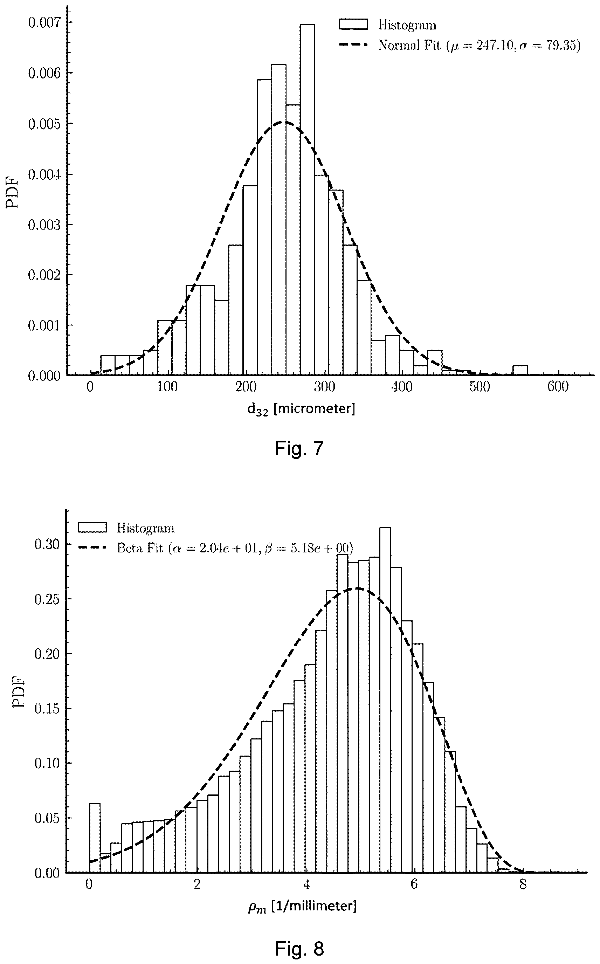

**Fig. 7** shows a histogram of the mean-diameter parameters of all specific fins of the first group of fins (which specific fins are located in the first volume 11) of the cross section 27 of Fig. 3. The histogram follows a normal distribution having a mean value of 247.1 µm and a standard deviation of 79.35 µm. The fit of the distribution (PDF) is also shown in Fig. 7.

**Fig. 8** shows a histogram of the density parameters of all pixels of the first area 37 of the pixelized representation 29 of the cross section 27 (see Fig. 4). Actually, the region 31 has been set to include the entire pixelized representation 29 (so that there are no margins 41 in that case). Hence, all specific fins of the first group of fins are located on the respective enlarged first area 37 and all specific fins of the second group of fins are located on the respective enlarged second area 39. Symmetric boundary conditions have been applied for calculating the density parameters for pixels for which the kernel 33 has no full overlap with the pixelized representation 29. The histogram follows a beta distribution with parameter alpha is 20.4 and parameter beta is 5.18. The mean value is 4.44 / mm. Here, the area of the portion of the cross section corresponding to the specific area of the pixelized representation covered by the kernel is 1.21 mm x 1.64 mm.

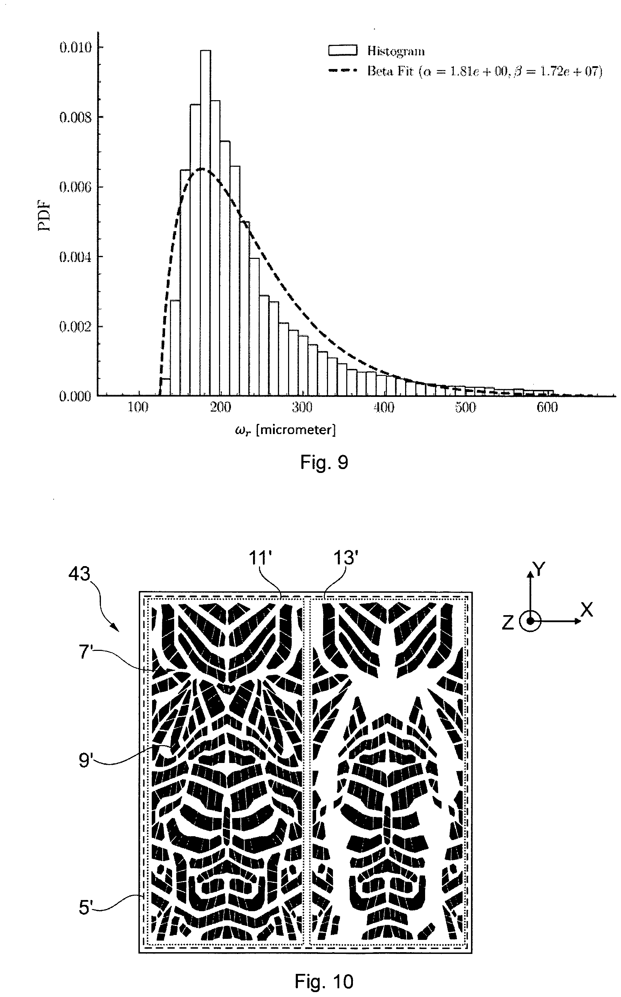

**Fig. 9** shows a histogram of the channel-width parameters of all pixels of the (enlarged) first area 37 of the pixelized representation 29 of the cross section 27 (see Fig. 4). The histogram follows a beta distribution with parameter alpha is 1.81 and parameter beta is 1.72e+7. The mean value is 288.32 µm. The fit of the distribution (PDF) is also shown in Fig. 9.

There can be provided further information on the design of the cooling element 1 shown in Fig. 3: The "fins-to-chip-ratio" is 32 %, the "channel-to-chip-ratio" is 68 % and the "fins-to-channel-ratio" is 48 %.

Thus, the size, the shape and/or the density of the fins 9 within the superior volume 5 may affect the cooling efficiency of the cooling element.

**Fig. 10** shows a base element 43 in a top view.

The base element 43 may be part of the cooling element 1 described above with reference to Figs. 1-9. For example, the cooling element 1 may comprise the base element 43 instead of base element 3 (however, in case base element 3 and base element 43 have different sizes, the size of the respective cover element and top element may have to be adapted).

Features of the base element 43 which are similar to the features of the base element 3 are labeled with the same reference signs but single dashed.

In the base element 43 a superior volume 5' can be defined in which a cooling liquid cooling agent can flow. The top surface of superior volume 5' is highlighted by a dashed rectangle. The superior volume 5' extends also along the Z direction. Within the superior volume 5' a network of interconnected channels 7' for guiding the cooling agent is provided. In Fig. 10 the black areas shown in superior volume 5' is the network of interconnected channels 7'. Within the superior volume 5' a plurality of fins 9' are provided, which fins contribute to the formation of boundaries of the channels of the network of interconnected channels 7'. The white islands correspond to the fins 9' and only one of which is labeled with a reference sign in Fig. 10. Here, the height of the superior volume 5' is identical to the height of the fins 9' and all fins 9' are provided and extend within the superior volume 5'.

To be more precise, there are fins of a first group of fins which are arranged within a definable first volume 11' (which is highlighted by a long-dashed rectangle). Furthermore, there are fins of a second group of fins which are respectively arranged within a definable second volume 13' (which is highlighted by another long-dashed rectangle). The superior volume 5' is the joint volume of the first volume 11' and the second volume 13'.

At least the fins of the first group of fins contribute at least in part to the formation of boundaries of the channels of at least one first part of the network of interconnected channels (namely the first part is provided within the first volume 11') and at least the fins of the second group of fins contribute at least in part to the formation of boundaries of the channels of at least one second part of the network of interconnected channels (namely the second part is provided within the second volume 13'). The superior volume 5' is the joint volume of first volume 11' and second volume 13'.

The fins of the first group of fins are arranged in a first irregular pattern. This first irregular pattern may be at least in part a result of an optimization process. The fins of the second group of fins are arranged in a second irregular pattern. This second irregular pattern may be at least in part a result of the same or another optimization process. The fins of the first group of fins are arranged in a different pattern than the fins of the second group of fins.

During use of a cooling element comprising the base element 43 a heat dissipation rate of the first part of the network of interconnected channels is different, especially higher, than a heat dissipation rate of the second part of the network of interconnected channels.

The first part of the network of interconnected channels and the second part of the network of interconnected channels are, hence, designed in such a way so as to dissipate different amounts of heat from different regions of the element to be cooled during use of the respective cooling element comprising the base element 43. This way different structures of the element to be cooled having different heat generations rates can be taken into account.

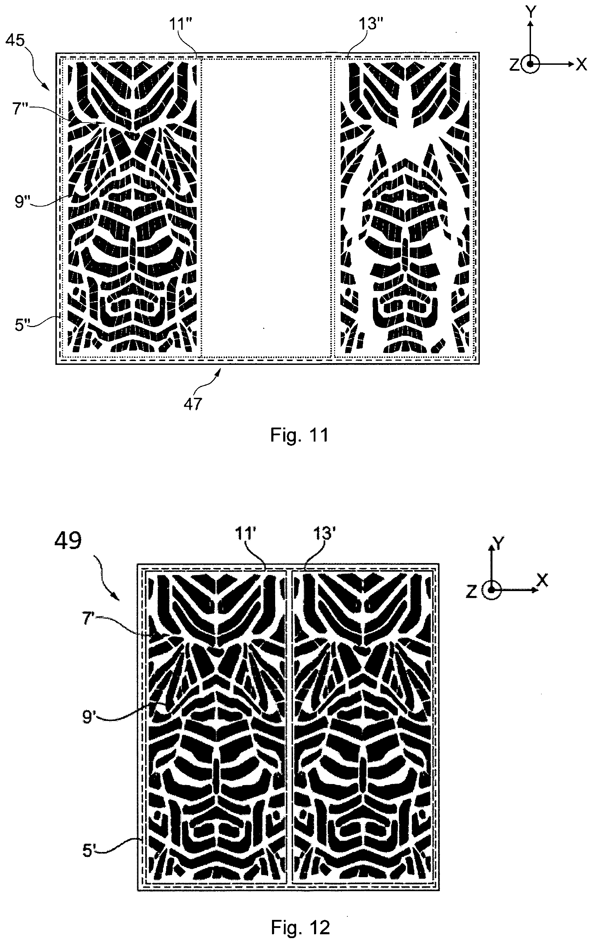

**Fig. 11** shows a base element 45 in a top view.

The base element 45 is similar to the base element 43 and may be part of the cooling element 1 described above with reference to Figs. 1-9. For example, the cooling element 1 may comprise the base element 45 instead of base element 3 (however, in case base element 3 and base element 45 have different sizes, the size of the respective cover element and top element may have to be adapted).

Features of the base element 45 which are similar to the features of the base element 3 and 43 are labeled with the same reference signs but double dashed.

Due to the similarity of base elements 43 and 45, only the differences are described here. Insofar, base element 45 comprises a definable third volume 47 (in Fig. 11 the third volume 47 is represented as a rectangular white area between first volume 11" and second volume 13"), which third volume 47 is free of fins, wherein the third volume 47 is comprised by the superior volume 5" and the superior volume 5" is identical to a joint volume of the first volume 11", the second volume 13" and the third volume 47. The third volume 47 is sandwiched between the first volume 11" and the second volume 13".

**Fig. 12** shows a base element 49 in a top view.

The base element 49 is similar to the base element 43 described above with respect to Fig. 10. Features of the base element 49 which are similar to the features of the base element 43 are labeled with the same reference signs. However, for base element 49, the fins of the first group of fins (provided in the first volume 11') and the fins of the second group of fins (provided in the second volume 13') are arranged in identical patterns (rather than different patterns as it was the case for the base element 43).

It is apparent to the person skilled in the art from the foregoing entire description that the patterns of the fins of the first and second groups of fins can be chosen in different manners.

For example, the fins of the first group of fins and the fins of the second group of fins may be arranged in different patterns. The two patterns may account for different heat dissipation rates.

For example, the fins of the first group of fins and the fins of the second group of fins may be arranged in identical patterns. The two patterns may account for identical heat dissipation rates.

For example, there may be also three group of fins (e.g. two first groups and one second group), and the fins of two groups of the three groups of fins may be arranged in identical patterns (e.g. a first pattern) and the fins of the remaining group of the three groups of fins may be arranged in a different pattern (e.g. a second pattern).The different design options allow to cover (especially singluar) coldplate configurations for chipset with multiple computing and/or memory chips. In this case the proposed cooling element may have a multitude of network of interconnected channels with associated heat dissipation rates.

Below, different items are provided, which describe preferred embodiments of the present invention.
Item 1. Cooling element being configured for heat-transferring contact with another element from which heat is to be dissipated during use, the cooling element comprising
   - one or more fins of at least one first group of fins arranged within at least one definable first volume, and
   - one or more fins of at least one second group of fins arranged within at least one definable second volume,

   wherein in a definable superior volume comprising the first volume and the second volume a network of interconnected channels for guiding a liquid cooling agent is provided,
   wherein the fins of each of the first group of fins and the second group of fins contribute to the formation of boundaries of the channels of the network of interconnected channels at least in part,
   wherein the fins of the first group of fins are arranged in a different pattern than the fins of the second group of fins.
Item 2. Cooling element according to item 1, wherein the cooling element comprises at least one inlet of the network of interconnected channels for supplying the liquid cooling agent to the network of interconnected channels and/or at least one outlet of the network of interconnected channels for discharging the liquid cooling agent from the network of interconnected channels.
Item 3. Cooling element according to any one of the preceding items, wherein in the first volume, in the second volume and/or in the superior volume, at least in a state in which the cooling element is in heat-transferring contact with the another element from which heat is to be dissipated during use, at least in regions the liquid cooling agent can flow, especially from the at least one inlet towards the at least one outlet, so that heat can be dissipated.
Item 4. Cooling element according to any one of the preceding items, wherein the fins of the second group of fins are arranged in a regular pattern, especially having a primitive geometry.
Item 5. Cooling element according to any one of the preceding items, wherein the fins of the first group of fins are arranged in an irregular pattern.
Item 6. Cooling element according to any one of the preceding items, wherein the fins of the first group of fins are arranged in a first irregular pattern and the fins of the second group of fins are arranged in a second irregular pattern.
Item 7. Cooling element according to any one of the preceding items, wherein the cooling element comprises at least one definable third volume, which third volume is free of fins, wherein preferably (i) the third volume is comprised by the superior volume and/or (ii) the superior volume is identical to a joint volume of the first, second and third volumes.
Item 8. Cooling element according to item 7, wherein the first volume and the third volume and/or the second volume and the third volume, respectively, are, preferably directly, adjacent to each other.
Item 9. Cooling element according to any one of items 7 to 8, wherein the third volume is arranged between, especially directly between, the first volume and the second volume, preferably the third volume is sandwiched between the first volume and the second volume.
Item 10. Cooling element according to any one of the preceding items, wherein the cooling element comprises at least one base element and wherein preferably the fins of the first group of fins are arranged on a first surface area of the base element and the fins of the second group of fins are arranged on a second surface area of the base element.
Item 11. Cooling element according to any one of the preceding items,
   wherein in at least one cross section of the superior volume lying within a cross-sectional plane of the cooling element, preferably in a defined area of at least 10 mm x 30 mm, all of the fins of the second group of fins have the same cross-sectional shape, and/or
   wherein in the cross section of the superior volume, preferably in a defined area of at least 25 mm x 35 mm, all of the fins of the first group of fins have a different cross-sectional shape to one another and preferably all of the fins of the second group of fins have a different cross-sectional shape to one another.
Item 12. Cooling element according to any one of the preceding items, wherein in the cross section of the superior volume, preferably in a defined area of at least 10 mm x 30 mm, each of the fins of the second group of fins has a ring-like and/or hexagonal and/or octagonal cross-sectional shape, wherein preferably the cross-sectional plane extends parallel to the first and/or second surface areas of the base element.
Item 13. Cooling element according to any one of the preceding items, wherein in the cross section of the superior volume, preferably in a defined area of at least 10 mm x 30 mm or of at least 25 mm x 35 mm, less than 5 % of, preferably less than 3 % of, more preferably none of, the fins in each case of the first group of fins and/or the second group of fins have a ring-like and/or disk-like cross-sectional shape.
Item 14. Cooling element according to any one of the preceding items, wherein the first volume and the second volume are, preferably directly, adjacent to each other, and preferably the superior volume is identical to a joint volume of the first and second volumes.
Item 15. Cooling element according to any one of the preceding items, wherein the cooling element comprises at least two second groups of fins each second group of fins arranged within one of at least two definable second volumes, wherein the at least one first volume is arranged between, especially directly between, at least two of the at least two second volumes, preferably the at least one first volume is sandwiched between at least two of the second volumes.
Item 16. Cooling element according to any one of the preceding items, wherein at least the fins of the first group of fins contribute at least in part to the formation of boundaries of the channels of at least one first part of the network of interconnected channels and wherein at least the fins of the second group of fins contribute at least in part to the formation of boundaries of the channels of at least one second part of the network of interconnected channels.
Item 17. Cooling element according to item 16, wherein during use of the cooling element a heat dissipation rate of the first part of the network of interconnected channels is different, especially higher, than a heat dissipation rate of the second part of the network of interconnected channels.
Item 18. Cooling element according to any one of the items 16 to 17, wherein the first part of the network of interconnected channels and the second part of the network of interconnected channels are designed in such a way so as to dissipate different amounts of heat from different regions of the element to be cooled during use of the cooling element, especially the first part of the network of interconnected channels is designed compared to the second part of the network of interconnected channels so as to dissipate a larger amount of heat from the element to be cooled, for example at least 3 times, at least 5 times or at least 10 times of the heat.
Item 19. Cooling element according to any one of the items 16 to 18, wherein the first part of the network of interconnected channels and the second part of the network of interconnected channels can be linked to regions of the element to be cooled which have different heat generation rates, especially the first part of the network of interconnected channels can be linked to a first region of the element to be cooled which has a higher heat generation rate than a second region of the element to be cooled to which the second part of the network of interconnected channels can be linked.
Item 20. Cooling element according to any one of the preceding items, wherein the cooling element comprises at least one cover element for covering the base element during use of the cooling element at least in some areas, wherein preferably the cover element and the base element are directly bonded, especially via thermocompression, and/or brazed to each other and/or wherein at least one sealing element, such as an O-ring, is arranged between the cover element and the base element.
Item 21. Cooling element according item 20, wherein the cover element comprises at least one recess, preferably at least two recesses, wherein
   a fluidical connection between the network of interconnected channels, especially the first part of the network of interconnected channels, and an environment of the cooling element is provided at least in part via a first recess of the at least one recess, which first recess preferably forms part of the at least one outlet and/or which is fluidically connected to the at least one outlet,
      and/or
   a fluidical connection between the network of interconnected channels, especially the second part of the network of interconnected channels, and an environment of the cooling element is provided at least in part via a second recess of the at least one recess, which second recess preferably forms part of the at least one inlet and/or which is fluidically connected to the at least one inlet.
Item 22. Cooling element according to item 21, wherein the first and/or second recess/es is/are formed as through holes arranged in the cover element.
Item 23. Cooling element according to any one of the items 20 to 22, wherein the cooling element comprises at least one top element which is or can be brought in contact with the cover element, and
   wherein preferably the top element comprises one or more, preferably integrally designed, manifolds, which manifolds preferably provide at least parts of, respectively, the inlet and/or outlet and/or cooperate with the at least one recess of the cover element, especially with the first and second recesses,
   wherein preferably the top element comprises means for connecting the manifolds to external piping and/or to external connection means for supplying the liquid cooling agent to the inlet and discharging the liquid cooling agent away from the outlet.
Item 24. Cooling element according to any one of the items 20 to 23, wherein the cover element and the top element are directly bonded and/or brazed to each other and/or wherein at least one sealing element, such as an O-ring, is arranged between the cover element and the top element.
Item 25. Cooling element according to any one of the items 20 to 24, wherein the cover element and/or the top element, respectively, is made of copper and/or is CNC machined.
Item 26. Cooling element according to any one of the items 20 to 25, wherein the cover element and the top element are designed in one piece.
Item 27. Cooling element according to any one of the items 10 to 26, wherein the base element is made of copper and/or a 3D printed structure.
Item 28. Cooling element according to any one of the items 10 to 27, wherein the base element is a single piece and/or wherein the fins of the first and/or second group of fins are integrally built with the base element.
Item 29. Cooling element according to any one of items 20 to 28, wherein the cover element, especially an inner surface of the cover element, contributes to the formation of boundaries of the channels of the network of interconnected channels at least in part in an assembled state of the cooling element.
Item 30. Cooling element according to any one of the preceding items, wherein the first volume is of cuboidal shape and all fins of the cooling element which are arranged within the first volume are fins of the first group of fins and/or the second volume is of cuboidal shape and all fins of the cooling element which are arranged within the second volume are fins of the second group of fins.
Item 31. Cooling element according to any one of the preceding items, wherein (i) in each of the first and second groups of fins the number of fins is larger than 10; (ii) among the fins in each case of the first group of fins and/or the second group of fins there are at least 10 fins which in at least one cross-sectional plane of the cooling element have different cross-sectional shapes; (iii) all fins of the second group of fins have in the cross-sectional plane of the cooling element identical cross-sectional shapes; (iv) the fins of the first group of fins are at least in part unevenly distributed within the first volume; (v) the fins of the second group of fins are at least in part unevenly distributed within the second volume; (vi) the fins of the second group of fins are evenly distributed within the second volume; and/or (vii) for each section of at least one, preferably two or more, sections of the first and/or second part of the network of interconnected channels, two or more fins of the first and/or second group of fins can be identified which contribute to the formation of the boundary of the respective section of the first and/or second part of the network of interconnected channels.
Item 32. Cooling element according to any one of the preceding items, wherein in the cross section of the superior volume for each fin of the first and second group of fins which lies within the cross section, hence being a specific fin, a perimeter can be associated with the respective specific fin,
   wherein for each specific fin a perimeter parameter *Pₑ* can be defined which takes the value of the length of its associated perimeter,
   and wherein preferably for each specific fin a surface can be associated with the respective specific fin, the surface being an area enclosed by the perimeter associated with the respective specific fin,
   wherein for each specific fin a surface parameter *Sₑ* can be defined which takes the value of the area of its associated surface.
Item 33. Cooling element according to item 32, wherein for each specific fin an equivalent-diameter parameter ${D}_{e} = 2 \sqrt{{S}_{e} / π}$, with *Sₑ* being the surface parameter of the respective specific fin, can be defined,
   wherein preferably for the specific fins in each case of the first group of fins and/or the second group of fins:
   - each equivalent-diameter parameter *Dₑ* has a value between 1 µm and 1500 µm, especially between 7 µm and 1300 µm,
   - the mean value of the equivalent-diameter parameters of the respective specific fins of the first group of fins and/or the second group of fins is between 100 µm and 700 µm, especially between 150 µm and 500 µm,
   - the median value of the equivalent-diameter parameters of the respective specific fins of the first group of fins and/or the second group of fins is between 150 µm and 700 µm, especially between 177 µm and 447 µm,
   - the mode value of the equivalent-diameter parameters of the respective specific fins of the first group of fins and/or the second group of fins is between 150 µm and 600 µm, especially between 171 µm and 485 µm, and/or
   - the standard deviation of the equivalent-diameter parameters of the respective specific fins of the first group of fins and/or the second group of fins is between 30 µm and 350 µm, especially between 50 µm and 200 µm, and/or is between ¼ and ½ of the mean value of the equivalent-diameter parameters of the specific fins.
Item 34. Cooling element according to item 33, wherein
   - the mean values of the equivalent-diameter parameters of the specific fins, respectively, of the first group of fins and the second group of fins, differ by at least 1 % and/or at most 100 %,
   - the median values of the equivalent-diameter parameters of the specific fins, respectively, of the first group of fins and the second group of fins, differ by at least 1 % and/or at most 100 %,
   - the mode values of the equivalent-diameter parameters of the specific fins, respectively, of the first group of fins and the second group of fins, differ by at least 1 % and/or at most 100 %,
      and/or
   - the standard deviations of the equivalent-diameter parameters of the specific fins, respectively, of the first group of fins and the second group of fins, differ by at least 1 % and/or at most 100 %.
Item 35. Cooling element according to any one of the items 33 to 34, wherein in each case of the first group of fins and/or the second group of fins a histogram of the equivalent-diameter parameters of the respective specific fins of the first group of fins and/or the second group of fins can be determined and each of which histograms follows a normal distribution, especially having a skewness between 0 and 2, especially between 0 and 1.7, preferably the two histograms have a different skewness by at least 1 % and/or at most 100 %, and/or a histogram of the equivalent-diameter parameters of the specific fins of the second group of fins can be determined and which histogram follows a normal distribution, especially having a skewness between 0 and 2, especially between 0 and 1.7.
Item 36. Cooling element according to any one of the items 32 to 35, wherein for each specific fin a roundness parameter $σ = 4 π \frac{{S}_{e}}{{P}_{e}^{2}}$, with *Pₑ* being the perimeter parameter and *Sₑ* being the surface parameter, respectively, of the respective specific fin, can be defined,
   wherein preferably for the specific fins in each case of the first group of fins and/or the second group of fins:
   - each roundness parameter *σ* has a value between 0.00 and 1.0, especially between 0.0 and 0.86,
   - the mean value of the roundness parameters of the respective specific fins of the first group of fins and/or the second group of fins is between 0.2 and 0.7, especially between 0.34 and 0.61,
   - the median value of the roundness parameters of the respective specific fins of the first group of fins and/or the second group of fins is between 0.2 and 0.8, especially between 0.31 and 0.65,
   - the mode value of the roundness parameters of the respective specific fins of the first group of fins and/or the second group of fins is between 0.1 and 0.8, especially between 0.2 and 0.69, and/or
   - the standard deviation of the roundness parameters of the respective specific fins of the first group of fins and/or the second group of fins is between 0.1 and 0.3, especially between 0.1 and 0.2.
Item 37. Cooling element according to item 36, wherein
   - the mean values of the roundness parameters of the specific fins, respectively, of the first group of fins and the second group of fins, differ by at least 1 % and/or at most 100 %,
   - the median values of the roundness parameters of the specific fins, respectively, of the first group of fins and the second group of fins, differ by at least 1 % and/or at most 100 %,
   - the mode values of the roundness parameters of the specific fins, respectively, of the first group of fins and the second group of fins, differ by at least 1 % and/or at most 100 %,
      and/or
   - the standard deviations of the roundness parameters of the specific fins, respectively, of the first group of fins and the second group of fins, differ by at least 1 % and/or at most 100 %.
Item 38. Cooling element according to any one of the items 36 to 37, wherein in each case of the first group of fins and/or the second group of fins a histogram of the roundness parameters of the respective specific fins of the first group of fins and/or the second group of fins can be determined and each of which histograms follows a beta distribution, especially having a skewness between -1.3 and 1.5, especially between 0.25 and 0.5, between 0.5 and 1.5 or between -1.2 and -0.05, preferably the two histograms have a different skewness by at least 1 % and/or at most 100 %, and/or a histogram of the roundness parameters of the specific fins of the second group of fins can be determined and which histogram follows a beta distribution, especially having a skewness between -1.3 and 1.5, especially between 0.25 and 0.5, between 0.5 and 1.5 or between -1.2 and -0.05.
Item 39. Cooling element according to any one of the items 32 to 38, wherein for each
   specific fin a mean-diameter parameter ${d}_{32} = 4 \frac{{S}_{e}}{{P}_{e}}$, with *Pₑ* being the perimeter parameter and *Sₑ* being the surface parameter, respectively, of the respective specific fin, can be defined,
   wherein preferably for the specific fins in each case of the first group of fins and/or the second group of fins:
      - each mean-diameter parameter *d*₃₂ has a value between 3 µm and 800 µm, especially between 7 µm and 685 µm,
      - the mean value of the mean-diameter parameters of the respective specific fins of the first group of fins and/or the second group of fins is between 100 µm and 350 µm, especially between 125 µm and 295 µm,
      - the median value of the mean-diameter parameters of the respective specific fins of the first group of fins and/or the second group of fins is between 100 µm and 400 µm, especially between 127 µm and 300 µm,
      - the mode value of the mean-diameter parameters of the respective specific fins of the first group of fins and/or the second group of fins is between 100 µm and 400 µm, especially between 130 µm and 300 µm, and/or
      - the standard deviation of the mean-diameter parameters of the respective specific fins of the first group of fins and/or the second group of fins is between 20 µm and 200 µm, especially between 30 µm and 80 µm, and/or is between ¼ and ½ of the mean value of the mean-diameter parameters of the specific fins.
Item 40. Cooling element according to the item 39, wherein
   - the mean values of the mean-diameter parameters of the specific fins, respectively, of the first group of fins and the second group of fins, differ by at least 1 % and/or at most 100 %,
   - the median values of the mean-diameter parameters of the specific fins, respectively, of the first group of fins and the second group of fins, differ by at least 1 % and/or at most 100 %,
   - the mode values of the mean-diameter parameters of the specific fins, respectively, of the first group of fins and the second group of fins, differ by at least 1 % and/or at most 100 %,
      and/or
   - the standard deviations of the mean-diameter parameters of the specific fins, respectively, of the first group of fins and the second group of fins, differ by at least 1 % and/or at most 100 %.
Item 41. Cooling element according to the item 39 or 40, wherein in each case of the first group of fins and/or the second group of fins a histogram of the mean-diameter parameters of the respective specific fins of the first group of fins and/or the second group of fins can be determined and each of which histograms follows a normal distribution, especially having a skewness between -0.4 and 0.8, especially between 0.2 and 0.8 or between -0.3 and 0.1, preferably the two histograms have a different skewness by at least 1 % and/or at most 100 %, and/or a histogram of the mean-diameter parameters of the specific fins of the second group of fins can be determined and which histogram follows a normal distribution, especially having a skewness between -0.4 and 0.8, especially between 0.2 and 0.8 or between -0.3 and 0.1.
Item 42. Cooling element according to any one of the preceding items, wherein a pixelized representation of the cross section, with the pixels of the pixelized representation having the value 1 for pixels of the perimeters of the specific fins and having the value 0 otherwise, can be provided,
   wherein a density parameter *ρₘ* can be defined which for each pixel within at least one region of the pixelized representation takes the value of a 2D moving average filter with its kernel centered at the respective pixel of the pixelized representation,
   and preferably the value of which is the ratio of the sum of the values of the pixels within a specific area of the pixelized representation which is an area of the pixelized representation which is covered by the kernel centered at the respective pixel of the pixelized representation multiplied with a predefined average length associated with a single pixel to the number of pixels of the kernel multiplied with the square of the predefined average length,
   wherein preferably one or more, preferably all, specific fins of the first group of fins are within at least one first area of the at least one region of the pixelized representation and/or one or more, preferably all, specific fins of the second group of fins are within at least one second area of the at least one region of the pixelized representation, which second area is different to and/or has no overlap with the first area,
   wherein preferably for the pixels in each case of the first area and/or the second area:
      - each density parameter *ρₘ* has a value between 0 / mm and 30 / mm, especially between 0 / mm and 12 / mm,
      - the mean value of the density parameters of all respective pixels within the first area and/or second area of the pixelized representation is between 3 / mm and 10 / mm, especially between 4 / mm and 7 / mm,
      - the median value of the density parameters of all respective pixels within the first area and/or second area of the pixelized representation is between 3 / mm and 10 / mm, especially between 4 / mm and 7 / mm,
      - the mode value of the density parameters of all respective pixels within the first area and/or second area of the pixelized representation is between 3 / mm and 8 / mm, especially between 4.17 /mm and 7.36 /mm, and/or
      - the standard deviation of the density parameters of all respective pixels within the first area and/or second area of the pixelized representation is between 0.5 / mm and 5 / mm, especially between 0.95 / mm and 1.57 / mm.
Item 43. Cooling element according to item 42, wherein
   - the mean values of the density parameters of all pixels, respectively, within the first area and the second area differ by at least 1 % and/or at most 100 %,
   - the median values of the density parameters of all pixels, respectively, within the first area and the second area differ by at least 1 % and/or at most 100 %,
   - the mode values of the density parameters of all pixels, respectively, within the first area and the second area differ by at least 1 % and/or at most 100 %,
      and/or
   - the standard deviations of the density parameters of all pixels, respectively, within the first area and the second area differ by at least 1 % and/or at most 100 %.
Item 44. Cooling element according to item 42 or 43, wherein in each case of the first area and/or the second area a histogram of the density parameters of respective all pixels of the first area and/or the second area of the pixelized representation can be determined and each of which histograms follows a beta distribution, especially having a skewness between -1 and 0.3, especially between -1 and -0.2 or between 0 and 3 or between 0.01 and 0.3, preferably the two histograms have a different skewness by at least 1 % and/or at most 100 %, and/or a histogram of the density parameters of all pixels of the second area of the pixelized representation can be determined and which histogram follows a beta distribution, especially having a skewness between -1 and 0.3, especially between -1 and -0.2 or between 0 and 3 or between 0.01 and 0.3.
Item 45. Cooling element according to any one of the items 42 to 44, wherein the predefined average length associated with a single pixel is an average length determined based at least in part on (i) an extension along the first dimension and an extension along the second dimension, respectively, of the cross section, and the number of pixels along the first dimension and the number of pixels along the second dimension, respectively, of the pixelized representation of the cross section and/or (ii) a minimum feature size and a specific number of pixels.
Item 46. Cooling element according to any one of the items 42 to 45, wherein the kernel has the same aspect ratio as the at least one region of the pixelized representation and/or as the pixelized representation.
**Item 47. Cooling** element according to any one of items 42 to 46, wherein the size of the kernel and the size of the at least one region of the pixelized representation are matched such that for each pixel within the at least one region of the pixelized representation the kernel, when centered at the respective pixel of the pixelized representation, has a complete overlap with the pixelized representation.
Item 48. Cooling element according to any one of items 42 to 47, wherein a channel-width parameter *ωᵣ* can be defined which for each pixel within the at least one region of the pixelized representation takes the value of the inverse of the density parameter *ρₘ* of the respective pixel,
   wherein preferably in each case of the first area and/or the second area
   - each channel-width parameter *ωᵣ* has a value between 30 µm and 900 µm, especially between 88 µm and 836 µm,
   - the mean value of the channel-width parameters of all respective pixels within the first area and/or second area of the pixelized representation is between 150 µm and 300 µm, especially between 155 µm and 260 µm,
   - the median value of the channel-width parameters of all respective pixels within the first area and/or second area of the pixelized representation is between 130 µm and 250 µm, especially between 147 µm and 240 µm,
   - the mode value of the channel-width parameters of all respective pixels within the first area and/or second area of the pixelized representation is between 120 µm and 250 µm, especially between 142 µm and 225 µm, and/or
   - the standard deviation of the channel-width parameters of all respective pixels within the first area and/or second area of the pixelized representation is between 30 µm and 90 µm, especially between 35 µm and 87 µm.
Item 49. Cooling element according to item 48, wherein
   - the mean values of the channel-width parameters of all pixels, respectively, within the first area and the second area differ by at least 1 % and/or at most 100 %,
   - the median values of the channel-width parameters of all pixels, respectively, within the first area and the second area differ by at least 1 % and/or at most 100 %,
   - the mode values of the channel-width parameters of all pixels, respectively, within the first area and the second area differ by at least 1 % and/or at most 100 %,
      and/or
   - the standard deviations of the channel-width parameters of all pixels, respectively, within the first area and the second area differ by at least 1 % and/or at most 100 %.
Item 50. Cooling element according to item 48 or 49, wherein in each case of the first area and/or the second area a histogram of the channel-width parameters of respective all pixels within the first area and/or the second area of the pixelized representation can be determined and each of which histograms follows a beta distribution, especially having a skewness between 0 and 3, especially between 1 and 3, preferably the two histograms have a different skewness by at least 1 % and/or at most 100 %, and/or a histogram of the channel-width parameters of all pixels within the second area of the pixelized representation can be determined and which histogram follows a beta distribution, especially having a skewness between 0 and 3, especially between 1 and 3.
Item 51. Cooling element according to any one of items 32 to 50, wherein the histograms of the parameters equivalent-diameter parameter, roundness parameter, mean-diameter parameter, density parameter and channel-width parameter can be determined, respectively, for the specific fins of the first group of fins and for the fins of the second group of fins,
   wherein for the specific fins in each case of the first group of fins and/or second group of fins at least two, preferably three or more, of the histograms follow a skewed distribution, at least one, preferably two or more, of which follows a left skewed distribution and at least one of which follows a right skewed distribution,
   especially for the specific fins in each case of the first group of fins and/or second group of fins the histogram of the equivalent-diameter parameter, mean-diameter parameter, density parameter and/or channel-width parameter follows a left skewed distribution and/or the histogram of the roundness parameters follow a right skewed distribution.
Item 52. Cooling element according to any one of the preceding items,
   wherein the height of the cooling element is between 1 µm and 2 cm,
   wherein the material of the specific fins is a material with good thermal conductivity and/or comprising at least one of nickel, brass, diamond, copper, aluminium, stainless steel, silicon, aluminium nitride, invar, kovar, Hastelloy, Inconel, or polymers,
   wherein the number of specific fins is between 2 and 300,000,000,
   wherein the cross section of the superior volume lying within the cross-sectional plane is rectangular and/or has an area of between 1 µm² and 500 cm²,
   wherein the at least one region of the pixelized representation is a rectangular region and/or corresponds to a portion of the cross section of the superior volume lying within the cross-sectional plane which has an area of at least 10 %, 20 %, 30 %, 50 % or 70 % of the total area of the cross-section of the cooling element,
   wherein the cooling element is designed as a cooling structure, especially as a microfluidic cooling structure,
   wherein at least some of the specific fins are obtained at least in part by extruding structures along a third dimension, especially by using an additive manufacturing technique, such as a 3D printing technique, and/or a deposition technique, such as electrodeposition and/or screen printing,
   wherein the superior volume is enclosed at least in part by a solid frame,
      and/or
   wherein the cooling element is or can be attached with another element from which heat is to be dissipated.
Item 53. Cooling element according to any one of the preceding items,
   wherein for the cross section of the superior volume within the cross-sectional plane the ratio of the sum of the surface areas of the specific fins to the area of the cross section is smaller than 0.5 or between 0.1 and 0.5,
   wherein for the cross section of the superior volume within the cross-sectional plane the ratio of the difference between the area of the cross section and the sum of the surface areas of the specific fins to the area of the cross section is larger than 0.5 or between 0.5 and 0.9,
   wherein for the cross section of the superior volume within the cross-sectional plane the ratio of the sum of the surface areas of the specific fins to the difference between the area of the cross section and the sum of the surface areas of the specific fins is between 0.15 and 0.9,
      and/or
      wherein the cross section of the superior volume lying within the cross-sectional plane of the cooling element is smaller than the cross section of the cooling element lying within that cross-sectional plane.
Item 54. Cooling element according to any one of the preceding items, wherein the cooling element is implemented as at least part of a coldplate, especially in form of a single coldplate, and/or at least part of a chip or at least in part in-chip.
Item 55. Cooling element according to any one of the preceding items, wherein the cooling element at least in part is designed and/or implemented as coldplate, especially a copper coldplate, preferably the base element is designed and/or implemented as coldplate.
Item 56. Cooling element according to any one of the preceding items, wherein the fins of the first group of fins and the fins of the second group of fins are provided on the same base element, especially on the same coldplate, or on different base elements, especially on different coldplates, wherein preferably the fins of the first group of fins are provided on at least one first base element, especially at least one first coldplate, and/or the fins of the second group of fins are provided on at least one second base element, especially at least one second coldplate
Item 57. Cooling element according to any one of the preceding items, wherein the fins of the first group of fins and the fins of the second group of fins are provided on the same chip or on different chips, especially computing chips and memory chips.
Item 58. Stack comprising at least one semiconductor device and at least one cooling element according to any one of the preceding items.
Item 59. Stack according to item 58, wherein the cooling element is integrally designed with the semiconductor device and/or wherein the cooling element is, preferably fixedly or releasably, attached to the semiconductor device.

The features disclosed in the description, the figures as well as the claims could be essential alone or in every combination for the realization of the invention in its different embodiments.

### List of reference numerals

- 1: Cooling element
- 3: Base element
- 5, 5', 5": Superior volume
- 7, 7', 7": Network of interconnected channels
- 9, 9', 9": Fin
- 11, 11', 11": First volume
- 13, 13', 13": Second volume
- 15: Cover element
- 17, 19: Recess
- 21: Top element
- 23, 25: Means
- 27: Cross section
- 29: Pixelized representation
- 31: Region
- 33: Kernel
- 35: Specific area
- 37: First area
- 39: Second area
- 41: Margin
- 43: Base element
- 45: Base element
- 47: Third volume
- 49: Base element
- *d*₃₂: Mean-diameter parameter
- *Dₑ*: Equivalent-diameter parameter
- H: Height of cross section
- H_{K}: Number of pixels
- N: Number of fins
- N_{CP}: Number of columns of pixels
- N_{RP}: Number of rows of pixels
- *Pₑ*: Perimeter Parameter
- *Sₑ*: Surface parameter
- W_{K}: Number of pixels
- W: Width of cross section
- X, Y, Z: Direction
- *σ*: Roundness parameter

## Claims

1. Cooling element being configured for heat-transferring contact with another element from which heat is to be dissipated during use, the cooling element comprising
- one or more fins of at least one first group of fins arranged within at least one definable first volume, and
- one or more fins of at least one second group of fins arranged within at least one definable second volume,
wherein in a definable superior volume comprising the first volume and the second volume a network of interconnected channels for guiding a liquid cooling agent is provided,
wherein the fins of each of the first group of fins and the second group of fins contribute to the formation of boundaries of the channels of the network of interconnected channels at least in part,
wherein the fins of the first group of fins are arranged in a different pattern than the fins of the second group of fins.

2. Cooling element according to claim 1, wherein the cooling element comprises at least one inlet of the network of interconnected channels for supplying the liquid cooling agent to the network of interconnected channels and/or at least one outlet of the network of interconnected channels for discharging the liquid cooling agent from the network of interconnected channels.

3. Cooling element according to any one of the preceding claims, wherein in the first volume, in the second volume and/or in the superior volume, at least in a state in which the cooling element is in heat-transferring contact with the another element from which heat is to be dissipated during use, at least in regions the liquid cooling agent can flow, especially from the at least one inlet towards the at least one outlet, so that heat can be dissipated.

4. Cooling element according to any one of the preceding claims, wherein the fins of the second group of fins are arranged in a regular pattern, especially having a primitive geometry.

5. Cooling element according to any one of the preceding claims, wherein the fins of the first group of fins are arranged in an irregular pattern.

6. Cooling element according to any one of the preceding claims, wherein the fins of the first group of fins are arranged in a first irregular pattern and the fins of the second group of fins are arranged in a second irregular pattern.

7. Cooling element according to any one of the preceding claims, wherein the cooling element comprises at least one definable third volume, which third volume is free of fins, wherein preferably (i) the third volume is comprised by the superior volume and/or (ii) the superior volume is identical to a joint volume of the first, second and third volumes.

8. Cooling element according to any one of the preceding claims, wherein at least the fins of the first group of fins contribute at least in part to the formation of boundaries of the channels of at least one first part of the network of interconnected channels and wherein at least the fins of the second group of fins contribute at least in part to the formation of boundaries of the channels of at least one second part of the network of interconnected channels.

9. Cooling element according to claim 8, wherein during use of the cooling element a heat dissipation rate of the first part of the network of interconnected channels is different, especially higher, than a heat dissipation rate of the second part of the network of interconnected channels.

10. Cooling element according to any one of the preceding claims, wherein the cooling element comprises at least one cover element for covering the base element during use of the cooling element at least in some areas, wherein preferably the cover element and the base element are directly bonded, especially via thermocompression, and/or brazed to each other and/or wherein at least one sealing element, such as an O-ring, is arranged between the cover element and the base element.

11. Cooling element according to any one of the preceding claims, wherein (i) in each of the first and second groups of fins the number of fins is larger than 10; (ii) among the fins in each case of the first group of fins and/or the second group of fins there are at least 10 fins which in at least one cross-sectional plane of the cooling element have different cross-sectional shapes; (iii) all fins of the second group of fins have in the cross-sectional plane of the cooling element identical cross-sectional shapes; (iv) the fins of the first group of fins are at least in part unevenly distributed within the first volume; (v) the fins of the second group of fins are at least in part unevenly distributed within the second volume; (vi) the fins of the second group of fins are evenly distributed within the second volume; and/or (vii) for each section of at least one, preferably two or more, sections of the first and/or second part of the network of interconnected channels, two or more fins of the first and/or second group of fins can be identified which contribute to the formation of the boundary of the respective section of the first and/or second part of the network of interconnected channels.

12. Cooling element according to any one of the preceding claims, wherein in the cross section of the superior volume for each fin of the first and second group of fins which lies within the cross section, hence being a specific fin, a perimeter can be associated with the respective specific fin,
wherein for each specific fin a perimeter parameter *Pₑ* can be defined which takes the value of the length of its associated perimeter,
and wherein preferably for each specific fin a surface can be associated with the respective specific fin, the surface being an area enclosed by the perimeter associated with the respective specific fin,
wherein for each specific fin a surface parameter *Sₑ* can be defined which takes the value of the area of its associated surface,
wherein for each specific fin an equivalent-diameter parameter ${D}_{e} = 2 \sqrt{{S}_{e} / π}$, with *Sₑ* being the surface parameter of the respective specific fin, can be defined,
wherein preferably for the specific fins in each case of the first group of fins and/or the second group of fins:
- each equivalent-diameter parameter *Dₑ* has a value between 1 µm and 1500 µm, especially between 7 µm and 1300 µm,
- the mean value of the equivalent-diameter parameters of the respective specific fins of the first group of fins and/or the second group of fins is between 100 µm and 700 µm, especially between 150 µm and 500 µm,
- the median value of the equivalent-diameter parameters of the respective specific fins of the first group of fins and/or the second group of fins is between 150 µm and 700 µm, especially between 177 µm and 447 µm,
- the mode value of the equivalent-diameter parameters of the respective specific fins of the first group of fins and/or the second group of fins is between 150 µm and 600 µm, especially between 171 µm and 485 µm, and/or
- the standard deviation of the equivalent-diameter parameters of the respective specific fins of the first group of fins and/or the second group of fins is between 30 µm and 350 µm, especially between 50 µm and 200 µm, and/or is between ¼ and ½ of the mean value of the equivalent-diameter parameters of the specific fins.

13. Cooling element according to any one of the preceding claims, wherein the cooling element is implemented as at least part of a coldplate, especially in form of a single coldplate, and/or at least part of a chip or at least in part in-chip.

14. Cooling element according to any one of the preceding claims, wherein the cooling element at least in part is designed and/or implemented as coldplate, especially a copper coldplate, preferably the base element is designed and/or implemented as coldplate.

15. Cooling element according to any one of the preceding claims, wherein the fins of the first group of fins and the fins of the second group of fins are provided on the same base element, especially on the same coldplate, or on different base elements, especially on different coldplates, wherein preferably the fins of the first group of fins are provided on at least one first base element, especially at least one first coldplate, and/or the fins of the second group of fins are provided on at least one second base element, especially at least one second coldplate.

16. Cooling element according to any one of the preceding claims, wherein the fins of the first group of fins and the fins of the second group of fins are provided on the same chip or on different chips, especially computing chips and memory chips.

17. Stack comprising at least one semiconductor device and at least one cooling element according to any one of the preceding claims.

18. Stack according to claim 17, wherein the cooling element is integrally designed with the semiconductor device and/or wherein the cooling element is, preferably fixedly or releasably, attached to the semiconductor device.
